# EUROPEAN PATENT APPLICATION

(11) **EP 4 679 146 A1**
(43) Date of publication of application: **14.01.2026**
(21) Application number: 24779919.0
(22) Date of filing: 22.03.2024
(51) Int. Cl.: G02B 5/18, B32B 3/30, B32B 7/023, G02B 1/111, G03F 7/20, G03F 7/26, G03F 7/40

(54) **COMPOSITION FOR FORMING RESIST UNDERLAYER FILM FOR MANUFACTURING OPTICAL DIFFRACTION BODY**

(30) Priority: 24.03.2023 JP 2023048360
(71) Applicant: Nissan Chemical Corporation, Tokyo 103-6119 (JP)
(72) Inventor: KISHIOKA, Takahiro, Toyama-shi, Toyama 939-2792 (JP); SAKAMOTO, Rikimaru, Toyama-shi, Toyama 939-2792 (JP); KAMIBAYASHI, Satoshi, Toyama-shi, Toyama 939-2792 (JP); MORIYA, Shunsuke, Toyama-shi, Toyama 939-2792 (JP)
(74) Representative: Müller-Boré & Partner Patentanwälte PartG mbB
(86) International application number: PCT/JP2024/011196
(87) International publication number: WO 2024/203800

(57) **Abstract**

A laminate for producing an optical diffractive body having a substrate and an optical diffraction grating layer disposed on the substrate and having a plurality of grooves using a photolithography or electron beam lithography technique, the laminate comprising:
the substrate;
a precursor layer that becomes the optical diffraction grating layer by being disposed on the substrate and forming the plurality of grooves therein; and
an antireflection organic resin layer disposed on the precursor layer.

## Description

### Technical Field

The present invention relates to a laminate, a method for producing a laminate, a method for producing an optical diffractive body, and a composition that is used therefor.

### Background Art

In recent years, as one image projection device, a head-mounted display, a head-up display, or the like that guides and displays an image from an image display device to the front of the eyes of an observer using a light guide has been commercialized. With the spreading use thereof as holographic and augmented/virtual reality (AR and VR) devices, development for the smaller size, wider angle of view, and higher efficiency thereof is underway. Amid such efforts, a diffractive optical element has attracted attention as one element for incidence into and emission from a light guide. This diffractive optical element enables the control of the advancing direction of light using a diffraction phenomenon and thus makes it possible to obtain a characteristic of a higher degree of freedom in light operation with a smaller size than diffractive optical elements for which reflection or refraction is used.

As a method for producing a diffractive optical element, there has been proposed a method for forming a diffractive optical element including providing an optical grating layer on a substrate; patterning a hard mask on the optical grating layer; forming a sacrificial layer on the hard mask, the sacrificial layer having a nonuniform height as measured from a top surface of the optical grating layer; and etching a plurality of angled trenches in the optical grating layer to form an optical grating, in the optical grating, a first depth of a first trench of the plurality of trenches being different from a second depth of a second trench of the plurality of trenches (see Patent Literature 1). In this technique, it is usual to use photolithography to pattern the hard mask layer.

### Citation List

### Patent Literature

Patent Literature 1: JP 2023-501527 W

### Summary of Invention

### Technical Problem

However, in the case of producing a diffractive optical element (optical diffractive body) using photolithography or electron beam lithography, it is difficult to obtain a desired resist pattern, to form a deep groove in the grating layer, or the like, and there is a problem in that desired lithographic characteristics cannot be obtained.

Therefore, an object of the present invention is to provide a laminate enabling a method for producing an optical diffractive body having imp, for example, roved lithographic characteristics, and a composition that is used in the production of the laminate.

In addition, another object of the present invention is to provide a method for producing the laminate and a method for producing an optical diffractive body using the laminate.

### Solution to Problem

As a result of intensive studies to solve the above problem, the present inventors have found that the above problem can be solved and have completed the present invention having the following gist.

That is, the present invention includes the following aspects.
[1] A laminate for producing an optical diffractive body having a substrate and an optical diffraction grating layer disposed on the substrate and having a plurality of grooves using a photolithography or electron beam lithography technique, the laminate having:
   the substrate;
   a precursor layer that becomes the optical diffraction grating layer by being disposed on the substrate and forming the plurality of grooves therein; and
   an antireflection organic resin layer disposed on the precursor layer.
[2] A laminate for producing an optical diffractive body having a substrate and an optical diffraction grating layer disposed on the substrate and having a plurality of grooves using a photolithography or electron beam lithography technique, the laminate having:
   the substrate;
   a precursor layer that becomes the optical diffraction grating layer by being disposed on the substrate and forming the plurality of grooves therein;
   an inorganic mask layer disposed on the precursor layer; and
   an antireflection organic resin layer disposed on the inorganic mask layer.
[3] A laminate for producing an optical diffractive body having a substrate and an optical diffraction grating layer disposed on the substrate and having a plurality of grooves using a photolithography or electron beam lithography technique, the laminate having:
   the substrate;
   a precursor layer that becomes the optical diffraction grating layer by being disposed on the substrate and forming the plurality of grooves therein;
   an organic resin layer disposed on the precursor layer; and
   a silicon-containing resin layer disposed on the organic resin layer.
[4] A laminate for producing an optical diffractive body having a substrate and an optical diffraction grating layer disposed on the substrate and having a plurality of grooves using a photolithography or electron beam lithography technique, the laminate having:
   the substrate;
   a precursor layer that becomes the optical diffraction grating layer by being disposed on the substrate and forming the plurality of grooves therein;
   an organic resin layer disposed on the precursor layer; and
   an inorganic material layer disposed on the organic resin layer.
[5] The laminate according to [4], further having: an antireflection organic resin layer disposed on the inorganic material layer.
[6] A composition for forming an antireflection organic resin layer that is used to form the antireflection organic resin layer in the laminate according to [1], [2], or [5] by coating.
[7] A composition for forming an organic resin layer that is used to form the organic resin layer in the laminate according to any one of [3] to [5] by coating.
[8] A composition for forming a silicon-containing resin layer that is used to form the silicon-containing resin layer in the laminate according to [3] by coating.
[9] A method for producing a laminate for producing the laminate according to [1], [2], or [5], the method including:
   a step of forming an antireflection organic resin layer by applying a composition for forming an antireflection organic resin layer.
[10] A method for producing a laminate for producing the laminate according to any one of [3] to [5], the method including:
   a step of forming the organic resin layer by applying a composition for forming an organic resin layer.
[11] A method for producing a laminate for producing the laminate according to [3], the method including:
   a step of forming the silicon-containing resin layer by applying a composition for forming a silicon-containing resin layer.
[12] A method for producing an optical diffractive body having a substrate and an optical diffraction grating layer disposed on the substrate and having a plurality of grooves, the method including:
   a step of forming a resist film on the antireflection organic resin layer of the laminate according to [1];
   a step of patterning the resist film by irradiating the resist film with light or an electron beam and developing the resist film;
   a step of patterning the antireflection organic resin layer by etching using the patterned resist film as a mask; and
   a step of etching the precursor layer using the patterned antireflection organic resin layer as a mask to form an optical diffraction grating layer having a plurality of grooves.
[13] A method for producing an optical diffractive body having a substrate and an optical diffraction grating layer disposed on the substrate and having a plurality of grooves, the method including:
   a step of forming a resist film on the antireflection organic resin layer of the laminate according to [2];
   a step of patterning the resist film by irradiating the resist film with light or an electron beam and developing the resist film;
   a step of patterning the inorganic mask layer and the antireflection organic resin layer by etching using the patterned resist film as a mask; and
   a step of etching the precursor layer using the patterned inorganic mask layer as a mask to form an optical diffraction grating layer having a plurality of grooves.
[14] The method for producing an optical diffractive body according to [13], further including: a step of forming a sacrificial layer having an inclined thickness on the patterned inorganic mask layer.
[15] A method for producing an optical diffractive body having a substrate and an optical diffraction grating layer disposed on the substrate and having a plurality of grooves, the method including:
   a step of forming a resist film on the silicon-containing resin layer of the laminate according to [3];
   a step of patterning the resist film by irradiating the resist film with light or an electron beam and developing the resist film;
   a step of patterning the silicon-containing resin layer by etching using the patterned resist film as a mask;
   a step of patterning the organic resin layer by etching using the patterned silicon-containing resin layer as a mask; and
   a step of etching the precursor layer using the patterned organic resin layer as a mask to form an optical diffraction grating layer having a plurality of grooves.
[16] The method for producing an optical diffractive body according to [15], further including: a step of forming a sacrificial layer having an inclined thickness on the patterned organic resin layer.
[17] A method for producing an optical diffractive body having a substrate and an optical diffraction grating layer disposed on the substrate and having a plurality of grooves, the method including:
   a step of forming a resist film on the inorganic material layer of the laminate according to [4];
   a step of patterning the resist film by irradiating the resist film with light or an electron beam and developing the resist film;
   a step of patterning the inorganic material layer by etching using the patterned resist film as a mask;
   a step of patterning the organic resin layer by etching using the patterned inorganic material layer as a mask; and
   a step of etching the precursor layer using the patterned organic resin layer as a mask to form an optical diffraction grating layer having a plurality of grooves.
[18] The method for producing an optical diffractive body according to [17], further including: a step of forming a sacrificial layer having an inclined thickness on the patterned organic resin layer.
[19] A method for producing an optical diffractive body having a substrate and an optical diffraction grating layer disposed on the substrate and having a plurality of grooves, the method including:
   a step of forming a resist film on the antireflection organic resin layer of the laminate according to [5];
   a step of patterning the resist film by irradiating the resist film with light or an electron beam and developing the resist film;
   a step of patterning the inorganic material layer and the antireflection organic resin layer by etching using the patterned resist film as a mask;
   a step of patterning the organic resin layer by etching using the patterned inorganic material layer as a mask; and
   a step of etching the precursor layer using the patterned organic resin layer as a mask to form an optical diffraction grating layer having a plurality of grooves.
[20] The method for producing an optical diffractive body according to [19], further including: a step of forming a sacrificial layer having an inclined thickness on the patterned organic resin layer.

### Advantageous Effects of Invention

According to the present invention, it is possible to provide a laminate enabling a method for producing an optical diffractive body having improved lithographic characteristics, and a composition that is used in the production of the laminate.

In addition, according to the present invention, it is possible to provide a method for producing the laminate and a method for producing an optical diffractive body using the laminate.

### Brief Description of Drawings

[Fig. 1] Fig. 1 is a schematic cross-sectional view of one example of a laminate of the present invention.
[Fig. 2] Fig. 2 is a schematic cross-sectional view of another example of the laminate of the present invention.
[Fig. 3] Fig. 3 is a schematic cross-sectional view of still another example of the laminate of the present invention.
[Fig. 4] Fig. 4 is a schematic cross-sectional view of far still another example of the laminate of the present invention.
[Fig. 5] Fig. 5 is a schematic cross-sectional view of even far still another example of the laminate of the present invention.
[Fig. 6A] Fig. 6A is a schematic cross-sectional view for describing one example of a method for producing an optical diffractive body of the present invention (part 1).
[Fig. 6B] Fig. 6B is a schematic cross-sectional view for describing the example of the method for producing an optical diffractive body of the present invention (part 2).
[Fig. 6C] Fig. 6C is a schematic cross-sectional view for describing the example of the method for producing an optical diffractive body of the present invention (part 3).
[Fig. 6D] Fig. 6D is a schematic cross-sectional view for describing the example of the method for producing an optical diffractive body of the present invention (part 4).
[Fig. 6E] Fig. 6E is a schematic cross-sectional view for describing the example of the method for producing an optical diffractive body of the present invention (part 5).
[Fig. 6F] Fig. 6F is a schematic cross-sectional view for describing the example of the method for producing an optical diffractive body of the present invention (part 6).
[Fig. 7A] Fig. 7A is a schematic cross-sectional view for describing another example of the method for producing an optical diffractive body of the present invention (part 1).
[Fig. 7B] Fig. 7B is a schematic cross-sectional view for describing the another example of the method for producing an optical diffractive body of the present invention (part 2).
[Fig. 7C] Fig. 7C is a schematic cross-sectional view for describing the another example of the method for producing an optical diffractive body of the present invention (part 3).
[Fig. 7D] Fig. 7D is a schematic cross-sectional view for describing the another example of the method for producing an optical diffractive body of the present invention (part 4).
[Fig. 7E] Fig. 7E is a schematic cross-sectional view for describing the another example of the method for producing an optical diffractive body of the present invention (part 5).
[Fig. 7F] Fig. 7F is a schematic cross-sectional view for describing the another example of the method for producing an optical diffractive body of the present invention (part 6).
[Fig. 7G] Fig. 7G is a schematic cross-sectional view for describing the another example of the method for producing an optical diffractive body of the present invention (part 7).
[Fig. 7H] Fig. 7H is a schematic cross-sectional view for describing the another example of the method for producing an optical diffractive body of the present invention (part 8).
[Fig. 8A] Fig. 8A is a schematic cross-sectional view for describing still another example of the method for producing an optical diffractive body of the present invention (part 1).
[Fig. 8B] Fig. 8B is a schematic cross-sectional view for describing the still another example of the method for producing an optical diffractive body of the present invention (part 2).
[Fig. 8C] Fig. 8C is a schematic cross-sectional view for describing the still another example of the method for producing an optical diffractive body of the present invention (part 3).
[Fig. 8D] Fig. 8D is a schematic cross-sectional view for describing the still another example of the method for producing an optical diffractive body of the present invention (part 4).
[Fig. 8E] Fig. 8E is a schematic cross-sectional view for describing the still another example of the method for producing an optical diffractive body of the present invention (part 5).
[Fig. 8F] Fig. 8F is a schematic cross-sectional view for describing the still another example of the method for producing an optical diffractive body of the present invention (part 6).
[Fig. 8G] Fig. 8G is a schematic cross-sectional view for describing the still another example of the method for producing an optical diffractive body of the present invention (part 7).
[Fig. 8H] Fig. 8H is a schematic cross-sectional view for describing the still another example of the method for producing an optical diffractive body of the present invention (part 8).
[Fig. 8I] Fig. 8I is a schematic cross-sectional view for describing the still another example of the method for producing an optical diffractive body of the present invention (part 9).
[Fig. 9A] Fig. 9A is a schematic cross-sectional view for describing far still another example of the method for producing an optical diffractive body of the present invention (part 1).
[Fig. 9B] Fig. 9B is a schematic cross-sectional view for describing the far still another example of the method for producing an optical diffractive body of the present invention (part 2).
[Fig. 9C] Fig. 9C is a schematic cross-sectional view for describing the far still another example of the method for producing an optical diffractive body of the present invention (part 3).
[Fig. 9D] Fig. 9D is a schematic cross-sectional view for describing the far still another example of the method for producing an optical diffractive body of the present invention (part 4).
[Fig. 9E] Fig. 9E is a schematic cross-sectional view for describing the far still another example of the method for producing an optical diffractive body of the present invention (part 5).
[Fig. 9F] Fig. 9F is a schematic cross-sectional view for describing the far still another example of the method for producing an optical diffractive body of the present invention (part 6).
[Fig. 9G] Fig. 9G is a schematic cross-sectional view for describing the far still another example of the method for producing an optical diffractive body of the present invention (part 7).
[Fig. 9H] Fig. 9H is a schematic cross-sectional view for describing the far still another example of the method for producing an optical diffractive body of the present invention (part 8).
[Fig. 9I] Fig. 9I is a schematic cross-sectional view for describing the far still another example of the method for producing an optical diffractive body of the present invention (part 9).
[Fig. 10A] Fig. 10A is a schematic cross-sectional view for describing even far still another example of the method for producing an optical diffractive body of the present invention (part 1).
[Fig. 10B] Fig. 10B is a schematic cross-sectional view for describing the even far still another example of the method for producing an optical diffractive body of the present invention (part 2).
[Fig. 10C] Fig. 10C is a schematic cross-sectional view for describing the even far still another example of the method for producing an optical diffractive body of the present invention (part 3).
[Fig. 10D] Fig. 10D is a schematic cross-sectional view for describing the even far still another example of the method for producing an optical diffractive body of the present invention (part 4).
[Fig. 10E] Fig. 10E is a schematic cross-sectional view for describing the even far still another example of the method for producing an optical diffractive body of the present invention (part 5).
[Fig. 10F] Fig. 10F is a schematic cross-sectional view for describing the even far still another example of the method for producing an optical diffractive body of the present invention (part 6).
[Fig. 10G] Fig. 10G is a schematic cross-sectional view for describing the even far still another example of the method for producing an optical diffractive body of the present invention (part 7).
[Fig. 10H] Fig. 10H is a schematic cross-sectional view for describing the even far still another example of the method for producing an optical diffractive body of the present invention (part 8).
[Fig. 10I] Fig. 10I is a schematic cross-sectional view for describing the even far still another example of the method for producing an optical diffractive body of the present invention (part 9).

### Description of Embodiments

### (Laminate)

A laminate of the present invention is a laminate for producing an optical diffractive body having a substrate and an optical diffraction grating layer disposed on the substrate and having a plurality of grooves using a photolithography or electron beam lithography technique (hereinafter referred to as "lithography technique" in some cases).

The optical diffractive body can be used as a head-mounted display or a head-up display that guides and displays an image from an image display device to the front of the eyes of an observer using a light guide.

The optical diffractive body is, for example, an element for incidence into and emission from a light guide.

The optical diffractive body is, for example, capable of controlling the advancing direction of light using a diffraction phenomenon.

A laminate of a first aspect has
a substrate,
a precursor layer that becomes an optical diffraction grating layer by being disposed on the substrate and forming a plurality of grooves therein, and
an antireflection organic resin layer disposed on the precursor layer.

In the case of producing an optical diffractive body using the lithography technique, there is a problem in that light or an electron beam that has been radiated to a resist film and has permeated the resist film during lithography is reflected by a substrate or an optical diffraction grating layer (precursor layer) that configures the optical diffractive body, depending on a situation, a stage or the like on which the substrate is placed, and returns to the resist film, which makes it difficult to obtain a desired resist pattern.

In the laminate of the first aspect, the laminate has the antireflection organic resin layer, whereby a desired resist pattern (for example, a resist pattern having a cross section controlled to be a rectangular shape) can be formed at the time of producing an optical diffractive body using the lithography technique. As a result, lithographic characteristics improve, and a desired optical diffraction grating layer can be easily fabricated with high accuracy.

In addition, in the laminate of the first aspect, the antireflection organic resin layer can be used as a mask for forming a plurality of grooves in the precursor layer after being patterned. In that case, an inorganic mask layer is not required. As a result, a desired optical diffraction grating layer can be easily fabricated with high accuracy, and the process of producing the optical diffractive body can be shortened.

In addition, the antireflection organic resin layer can be formed by applying a composition for forming an antireflection organic resin layer to be described below. As a result, the optical diffractive body can be produced at low cost.

A laminate of a second aspect has
a substrate,
a precursor layer that becomes an optical diffraction grating layer by being disposed on the substrate and forming a plurality of grooves therein,
an inorganic mask layer disposed on the precursor layer, and
an antireflection organic resin layer disposed on the inorganic mask layer.

In the laminate of the second aspect, the laminate has the antireflection organic resin layer, whereby a desired resist pattern can be formed at the time of producing an optical diffractive body using the lithography technique. As a result, lithographic characteristics improve, and a desired optical diffraction grating layer can be easily fabricated with high accuracy.

In addition, the inorganic mask layer is more highly resistant to etching than the antireflection organic resin layer. Therefore, in the laminate of the second aspect, the joint use of the antireflection organic resin layer and the inorganic mask layer makes it possible to easily fabricate a desired optical diffraction grating layer with higher accuracy.

In addition, the antireflection organic resin layer can be formed by applying the composition for forming an antireflection organic resin layer to be described below. As a result, the optical diffractive body can be produced at low cost.

A laminate of a third aspect has
a substrate,
a precursor layer that becomes an optical diffraction grating layer by being disposed on the substrate and forming a plurality of grooves therein,
an organic resin layer disposed on the precursor layer, and
a silicon-containing resin layer disposed on the organic resin layer.

In the case of producing an optical diffractive body using the lithography technique, there is a problem in that as a groove that is formed in an optical diffraction grating layer becomes finer, it becomes more difficult to form a deep groove in the optical diffraction grating layer. This is because when a resist film thick enough to have sufficient mask performance for the formation of a deep groove is used, a resist pattern is more likely to collapse as the groove becomes finer.

The laminate of the third aspect has an organic resin layer and a silicon-containing resin layer. Since the organic resin layer can be made thick, it is possible to form a deep groove in an optical diffraction grating layer using the patterned organic resin layer having a high aspect ratio as a mask. Therefore, at the time of producing an optical diffractive body using the lithography technique, it is possible to easily make a groove that is formed in an optical diffraction grating layer thick.

In addition, since modification of a layer (for example, introduction of a functional group or the like, a change in density of the layer, or the like) is easier in the silicon-containing resin layer than in an inorganic material layer to be described below, it is easy to modify the characteristics (for example, hydrophilicity and hydrophobicity) of the layer. As a result, it becomes easy to improve the adhesion with a resist film, which will be an upper layer, or to further improve the lithographic characteristics (for example, sensitivity) of the resist film.

In addition, the organic resin layer can be formed by applying the composition for forming an organic resin layer to be described below. As a result, the optical diffractive body can be produced at low cost.

In addition, the silicon-containing resin layer can be formed by applying a composition for forming a silicon-containing resin layer to be described below. As a result, the optical diffractive body can be produced at low cost.

A laminate of a fourth aspect has
a substrate,
a precursor layer that becomes an optical diffraction grating layer by being disposed on the substrate and forming a plurality of grooves therein,
an organic resin layer disposed on the precursor layer, and
an inorganic material layer disposed on the organic resin layer.

The laminate of the fourth aspect has an organic resin layer and an inorganic material layer. Since the organic resin layer can be made thick, it is possible to form a deep groove in an optical diffraction grating layer using the patterned organic resin layer having a high aspect ratio as a mask. Therefore, at the time of producing an optical diffractive body using the lithography technique, it is possible to easily make a groove that is formed in an optical diffraction grating layer thick.

In addition, the organic resin layer can be formed by applying the composition for forming an organic resin layer to be described below. As a result, the optical diffractive body can be produced at low cost.

A laminate of a fifth aspect has
a substrate,
a precursor layer that becomes an optical diffraction grating layer by being disposed on the substrate and forming a plurality of grooves therein,
an organic resin layer disposed on the precursor layer,
an inorganic material layer disposed on the organic resin layer, and
an antireflection organic resin layer disposed on the inorganic material layer.

The laminate of the fifth aspect has an organic resin layer and an inorganic material layer. Since the organic resin layer can be made thick, it is possible to form a deep groove in an optical diffraction grating layer using the patterned organic resin layer having a high aspect ratio as a mask. Therefore, at the time of producing an optical diffractive body using the lithography technique, it is possible to easily make a groove that is formed in an optical diffraction grating layer thick.

In addition, the laminate has the antireflection organic resin layer, whereby a desired resist pattern can be formed at the time of producing an optical diffractive body using the lithography technique. As a result, lithographic characteristics improve, and a desired optical diffraction grating layer can be easily fabricated with high accuracy.

In addition, the organic resin layer can be formed by applying the composition for forming an organic resin layer to be described below. As a result, the optical diffractive body can be produced at low cost.

In addition, the antireflection organic resin layer can be formed by applying the composition for forming an antireflection organic resin layer to be described below. As a result, the optical diffractive body can be produced at low cost.

The laminate may further have a resist film.

The laminates of the first aspect, the second aspect, and the fifth aspect may have a resist film disposed on the antireflection organic resin layer.

The laminate of the third aspect may have a resist film disposed on the silicon-containing resin layer.

The laminate of the fourth aspect may have a resist film disposed on the inorganic material layer.

### <Substrate>

The material of the substrate is not particularly limited, and examples thereof include optically transparent materials.

Examples of the material of the substrate include glass, quartz, silicon, organic resins, and the like.

The size, structure, and thickness of the substrate are not particularly limited.

The thickness of the substrate is, for example, 100 µm to 10 mm.

The substrate may have an etching stop layer on the surface.

The etching stop layer is made of, for example, a material being resistant to etching of the precursor layer.

The material of the etching stop layer is not particularly limited, and examples thereof include optically transparent materials.

Examples of the material of the etching stop layer include silicon oxide, silicon nitride, titanium nitride, tantalum nitride, silicon carbide, and the like.

The size, structure, and thickness of the etching stop layer are not particularly limited.

The thickness of the etching stop layer is, for example, 10 nm to 100 nm or the like.

The etching stop layer is formed by, for example, a chemical vapor deposition (CVD) process, a physical vapor deposition (PVD) process, or the like.

### <Precursor layer>

The precursor layer is a layer that becomes an optical diffraction grating layer by forming a plurality of grooves therein.

The precursor layer is, for example, a smooth layer.

The material of the precursor layer is not particularly limited, and examples thereof include optically transparent materials.

Examples of the material of the precursor layer include silicon oxide, silicon nitride, titanium nitride, glass, organic resins, and the like.

The size and structure of the precursor layer are not particularly limited.

The refractive index of the precursor layer is not particularly limited and is, for example, 1.3 to 2.4 with respect to light of 300 to 1,000 nm, for example, 633 nm.

The thickness of the precursor layer is not particularly limited and is, for example, 150 nm to 1,000 nm.

The precursor layer is formed by, for example, a CVD process, a PVD process, a coating process, or the like.

### <Inorganic mask layer>

The inorganic mask layer is a layer that functions as a mask for forming a plurality of grooves in the precursor layer after being patterned.

The inorganic mask layer is made of an inorganic material.

The material of the inorganic mask layer is not particularly limited and is, for example, a material having etching resistance at the time of forming a plurality of grooves in the precursor layer. Examples of such a material include titanium nitride and the like.

The thickness of the inorganic mask layer is not particularly limited and is, for example, 1 nm to 1000 nm.

The inorganic mask layer is formed by, for example, a CVD process, a PVD process, or the like.

### <Antireflection organic resin layer>

The antireflection organic resin layer is a layer that prevents light or an electron beam that has been radiated to the resist film and has permeated the resist film for photolithography or electron beam lithography from returning to the resist film.

The antireflection organic resin layer contains an organic resin.

The thickness of the antireflection organic resin layer is not particularly limited, but is preferably 1 nm to 300 nm, more preferably 3 nm to 250 nm, and particularly preferably 5 nm to 200 nm.

Preferably, the antireflection organic resin layer can be formed by applying the composition for forming an antireflection organic resin layer to be described below.

### <Organic resin layer>

The organic resin layer is jointly used with the silicon-containing resin layer or the inorganic material layer in the laminate.

The organic resin layer contains an organic resin.

The thickness of the organic resin layer is not particularly limited, but is preferably 1 nm to 2000 nm, more preferably 10 nm to 1500 nm, and particularly preferably 50 nm to 1000 nm.

Preferably, the organic resin layer can be formed by applying the composition for forming an organic resin layer to be described below.

### <Silicon-containing resin layer>

The silicon-containing resin layer contains, for example, a polysiloxane.

The thickness of the silicon-containing resin layer is not particularly limited, but is preferably 1 nm to 500 nm, more preferably 2 nm to 400 nm, and particularly preferably 5 nm to 200 nm.

The thickness of the silicon-containing resin layer is not particularly limited, but is preferably 0.001 times to 2 times, more preferably 0.005 times to 1 time, and particularly preferably 0.01 times to 0.5 times the thickness of the organic resin layer.

Preferably, the silicon-containing resin layer can be formed by applying the composition for forming a silicon-containing resin layer to be described below.

### <Inorganic material layer>

The inorganic material layer is a layer made of an inorganic material.

Examples of the material of the inorganic material layer include silicon oxynitride (for example, SiON) and the like.

The thickness of the inorganic material layer is not particularly limited, but is preferably 1 nm to 500 nm, more preferably 2 nm to 400 nm, and particularly preferably 5 nm to 200 nm.

The thickness of the inorganic material layer is not particularly limited, but is preferably 0.001 times to 2 times, more preferably 0.005 times to 1 time, and particularly preferably 0.01 times to 0.5 times the thickness of the organic resin layer.

The inorganic material layer is formed by, for example, a CVD process, a PVD process, a coating process, or the like.

### <Resist film>

The resist film is not particularly limited as long as the resist film is a resist film that is used in photolithography or electron beam lithography.

The thickness of the resist film is not particularly limited, but is preferably 10 nm to 30 µm, more preferably 50 nm to 20 µm, and particularly preferably 100 nm to 10 µm.

The resist film is formed using, for example, a resist material to be described below.

Hereinafter, one example of the laminate of the present invention will be described using the drawings.

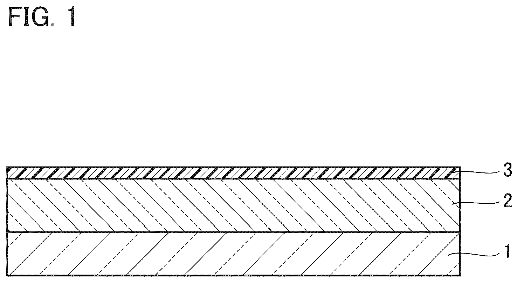

Fig. 1 is a schematic cross-sectional view of one example of the laminate of the present invention.

The laminate of Fig. 1 is a laminate of one example of the first aspect.

The laminate of Fig. 1 has a substrate 1, a precursor layer 2, and an antireflection organic resin layer 3.

The precursor layer 2 is disposed on the substrate 1.

The antireflection organic resin layer 3 is disposed on the precursor layer 2.

The laminate of the first aspect may have a resist film disposed on the antireflection organic resin layer 3.

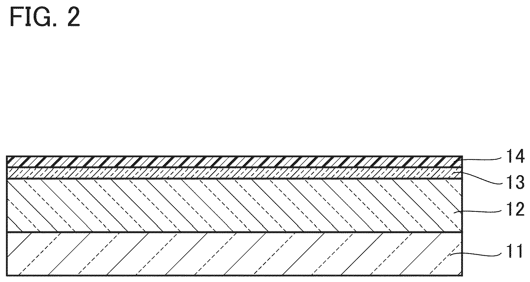

Fig. 2 is a schematic cross-sectional view of another example of the laminate of the present invention.

The laminate of Fig. 2 is a laminate of one example of the second aspect.

The laminate of Fig. 2 has a substrate 11, a precursor layer 12, an inorganic mask layer 13, and an antireflection organic resin layer 14.

The precursor layer 12 is disposed on the substrate 11.

The inorganic mask layer 13 is disposed on the precursor layer 12.

The antireflection organic resin layer 14 is disposed on the inorganic mask layer 13.

The laminate of the second aspect may have a resist film disposed on the antireflection organic resin layer 14.

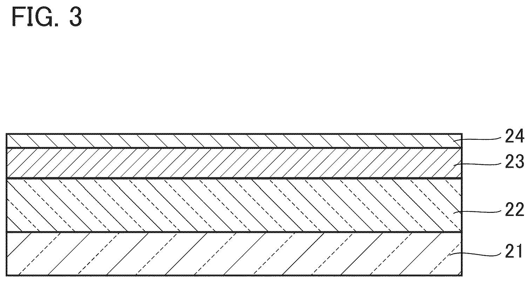

Fig. 3 is a schematic cross-sectional view of still another example of the laminate of the present invention.

The laminate of Fig. 3 is a laminate of one example of the third aspect.

The laminate of Fig. 3 has a substrate 21, a precursor layer 22, an organic resin layer 23, and a silicon-containing resin layer 24.

The precursor layer 22 is disposed on the substrate 21.

The organic resin layer 23 is disposed on the precursor layer 22.

The silicon-containing resin layer 24 is disposed on the organic resin layer 23.

The laminate of the third aspect may have a resist film disposed on the silicon-containing resin layer 24.

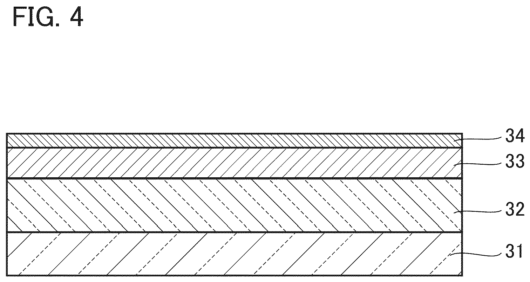

Fig. 4 is a schematic cross-sectional view of far still another example of the laminate of the present invention.

The laminate of Fig. 4 is a laminate of one example of the fourth aspect.

The laminate of Fig. 4 has a substrate 31, a precursor layer 32, an organic resin layer 33, and an inorganic material layer 34.

The precursor layer 32 is disposed on the substrate 31.

The organic resin layer 33 is disposed on the precursor layer 32.

The inorganic material layer 34 is disposed on the organic resin layer 33.

The laminate of the fourth aspect may have a resist film disposed on the inorganic material layer 34.

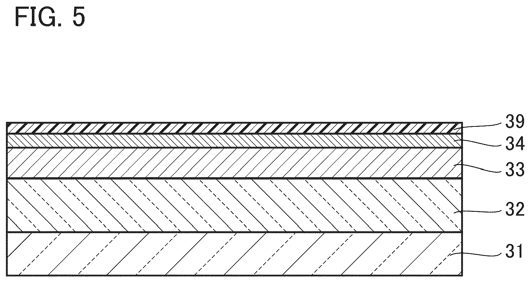

Fig. 5 is a schematic cross-sectional view of even far still another example of the laminate of the present invention.

The laminate of Fig. 5 is a laminate of one example of the fifth aspect.

The laminate of Fig. 5 has the substrate 31, the precursor layer 32, the organic resin layer 33, the inorganic material layer 34, and an antireflection organic resin layer 39.

The precursor layer 32 is disposed on the substrate 31.

The organic resin layer 33 is disposed on the precursor layer 32.

The inorganic material layer 34 is disposed on the organic resin layer 33.

The antireflection organic resin layer 39 is disposed on the inorganic material layer 34.

The laminate of the fifth aspect may have a resist film disposed on the antireflection organic resin layer 39.

### (Composition for forming antireflection organic resin layer, composition for forming organic resin layer, and composition for forming silicon-containing resin layer)

A composition for forming an antireflection organic resin layer of the present invention is a composition that is used to form the antireflection organic resin layer by coating.

A composition for forming an organic resin layer of the present invention is a composition that is used to form the organic resin layer by coating.

A composition for forming a silicon-containing resin layer of the present invention is a composition that is used to form the silicon-containing resin layer by coating.

Hereinafter, one example of the composition for forming an antireflection organic resin layer, the composition for forming an organic resin layer, and the composition for forming a silicon-containing resin layer will be described.

### <Composition for forming antireflection organic resin layer and composition for forming organic resin layer>

The composition for forming an antireflection organic resin layer and the composition for forming an organic resin layer that can be used in the present invention are not particularly limited, and for example, a well-known composition for forming an antireflection organic resin layer and a well-known composition for forming an organic resin layer that are used in the lithography technique can be used.

These compositions contain, for example, an organic resin and a solvent. The compositions may further contain a crosslinking agent, a curing catalyst, or the like.

Hereinafter, one example thereof will be described. In the following examples, even a composition for antireflection can be used to form organic resin layers (for example, the organic resin layers of the third aspect to the fifth aspect). In addition, in the following examples, even a composition not for antireflection can be used to form antireflection organic resin layers (for example, the antireflection organic resin layers of the first aspect and the fifth aspect) in some cases.

As the composition for forming an antireflection organic resin layer and the composition for forming an organic resin layer, it is possible to use, for example, compositions described in WO 02/086624. The entire disclosure of WO 02/086624 is incorporated into the present application by reference.

Specifically, the compositions are, for example, a composition containing cyanuric acid, a derivative thereof, or a resin containing a structural unit derived therefrom as a component.

As the composition for forming an antireflection organic resin layer and the composition for forming an organic resin layer, it is possible to use, for example, compositions described in WO 03/017002. The entire disclosure of WO 03/017002 is incorporated into the present application by reference.

Specifically, the compositions are, for example, a composition containing a resin containing a lactone structure and a crosslinking agent.

As the composition for forming an antireflection organic resin layer and the composition for forming an organic resin layer, it is possible to use, for example, compositions described in WO 2004/074938. The entire disclosure of WO 2004/074938 is incorporated into the present application by reference.

Specifically, the compositions are, for example, a composition containing a polymer consisting of a unit structure represented by the following formula (1): 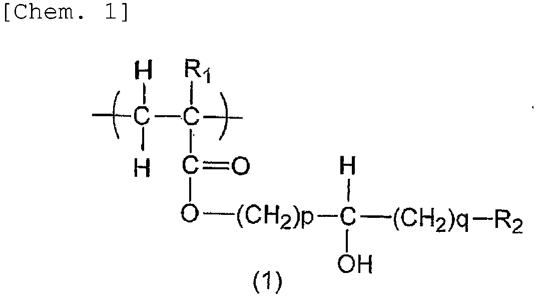 (in the formula, R₁ represents a hydrogen atom, a methyl group, a chlorine atom, or a bromine atom, R₂ represents a hydrogen atom or a hydroxyl group, p represents a number of 1, 2, 3, or 4, and q represents a number of 0, 1, 2, or 3) and containing a component having a molecular weight of 3000 or less in a proportion of 20% or less, a crosslinking agent, and a solvent.

In addition, the compositions are, for example, a composition containing a polymer consisting of the unit structure represented by the formula (1) and a unit structure represented by the following formula (2): 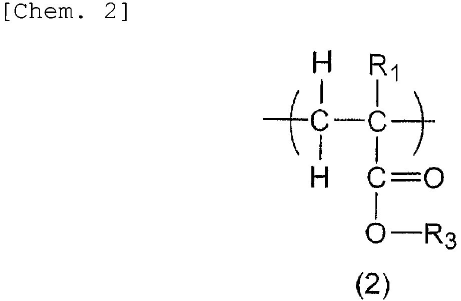 (in the formula, R₁ is the same as above, R₃ represents an alkyl group having 1 to 8 carbon atoms, a benzyl group, an alkyl group having 1 to 6 carbon atoms and having at least one fluorine atom, chlorine atom, or bromine atom as a substituent, or an alkyl group having 1 to 6 carbon atoms and having at least one alkoxy group having 1 to 6 carbon atoms as a substituent) and containing a component having a molecular weight of 3000 or less in a proportion of 20% or less, the ratio of the unit structure represented by the formula (1) to the polymer being 0.10 to 0.95, a crosslinking agent, and a solvent (here, the sum of the molar ratio of the unit structure represented by the formula (1) and the molar ratio of the unit structure represented by the formula (2) is set to one).

As the composition for forming an antireflection organic resin layer and the composition for forming an organic resin layer, it is possible to use, for example, compositions described in WO 2005/013601. The entire disclosure of WO 2005/013601 is incorporated into the present application by reference.

Specifically, the compositions are, for example, a composition containing a compound having a protected carboxyl group represented by the following formula (1): 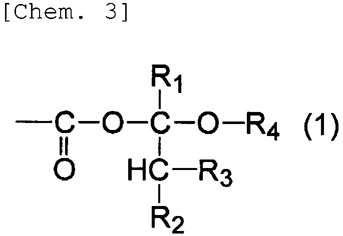 (in the formula, R₁, R₂, and R₃ each represent a hydrogen atom or an alkyl group having 1 to 10 carbon atoms, R₄ represents an alkyl group having 1 to 10 carbon atoms, and R₃ and R₄ may bond to each other to form a ring), a compound having a group capable of reacting with a carboxyl group, and a solvent.

As the composition for forming an antireflection organic resin layer and the composition for forming an organic resin layer, it is possible to use, for example, compositions described in WO 2005/022261. The entire disclosure of WO 2005/022261 is incorporated into the present application by reference.

Specifically, the compositions are, for example, a composition containing a polyamic acid having a structure represented by the following formula (1): 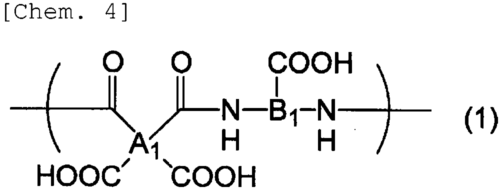 (in the formula, A₁ represents a tetravalent organic group, and B₁ represents a trivalent organic group), a compound having at least two epoxy groups, and a solvent.

In addition, specifically, the compositions are, for example, a composition containing a polyamic acid having the structure represented by the formula (1) and a structure represented by the following formula (2): 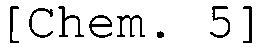 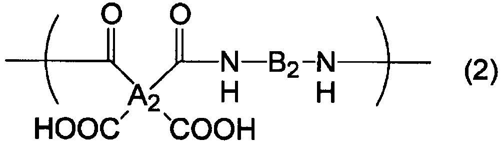 (in the formula, A₂ represents a tetravalent organic group, and B₂ represents a divalent organic group), a compound having at least two epoxy groups, and a solvent.

As the composition for forming an antireflection organic resin layer and the composition for forming an organic resin layer, it is possible to use, for example, compositions described in WO 2005/098542. The entire disclosure of WO 2005/098542 is incorporated into the present application by reference.

Specifically, the compositions are, for example, a composition containing a polymer having a structure represented by the following formula (1): 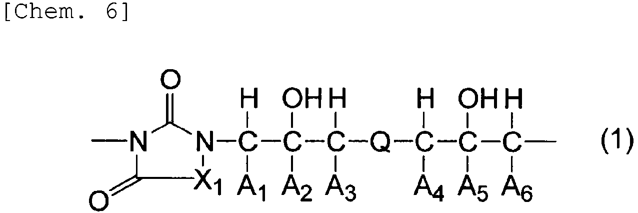 (in the formula, A₁, A₂, A₃, A₄, A₅, and A₆ each represent a hydrogen atom, a methyl group, or an ethyl group, X₁ represents a formula (2), a formula (3), a formula (4), or a formula (5): 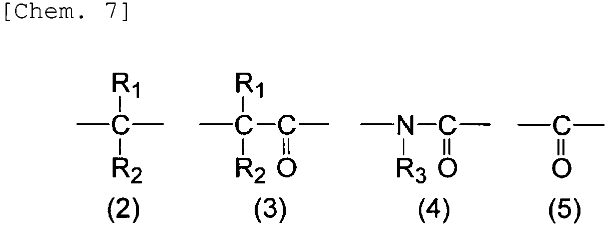 (in the formula, R₁ and R₂ each represent a hydrogen atom, an alkyl group having 1 to 6 carbon atoms, an alkenyl group having 3 to 6 carbon atoms, a benzyl group, or a phenyl group, in addition, the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms, R₁ and R₂ may bond to each other to form a ring having 3 to 6 carbon atoms, R₃ represents an alkyl group having 1 to 6 carbon atoms, an alkenyl group having 3 to 6 carbon atoms, a benzyl group, or a phenyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms), and Q represents a formula (6) or a formula (7): 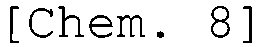 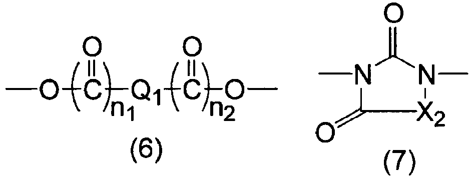 (in the formula, Q₁ represents an alkylene group having 1 to 10 carbon atoms, a phenylene group, a naphthylene group, or an anthrylene group, in addition, the phenylene group, the naphthylene group, and the anthrylene group may be each substituted with a group selected from the group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms, n₁ and n₂ each represent 0 or 1, and X₂ represents the formula (2), the formula (3), or the formula (5)) and a solvent.

As the composition for forming an antireflection organic resin layer and the composition for forming an organic resin layer, it is possible to use, for example, compositions described in WO 2006/027950. The entire disclosure of WO 2006/027950 is incorporated into the present application by reference.

Specifically, the compositions are, for example, a composition containing a polyamic acid having a structure represented by the following formula (1) and the following formula (2): 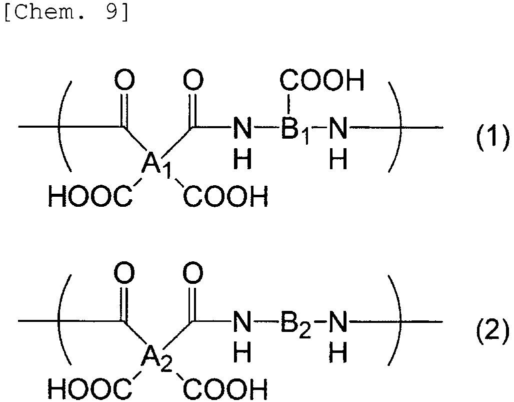 (in the formula, A₁ and A₂ represent a tetravalent organic group, B₁ represents a trivalent organic group, and B₂ represents a divalent organic group), a compound having at least two epoxy groups, a light-absorbing compound having a molar absorption coefficient of 5,000 to 100,000 (l/mol·cm) with respect to light having a wavelength of 365 nm, and a solvent.

As the composition for forming an antireflection organic resin layer and the composition for forming an organic resin layer, it is possible to use, for example, compositions described in WO 2006/077748. The entire disclosure of WO 2006/077748 is incorporated into the present application by reference.

Specifically, the compositions are, for example, a composition containing a compound having two or more protected carboxyl groups represented by the following formula (1): 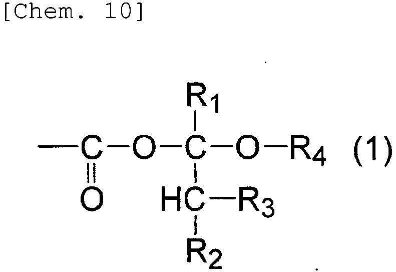 (in the formula, R₁, R₂, and R₃ each represent a hydrogen atom or an alkyl group having 1 to 10 carbon atoms, R₄ represents an alkyl group having 1 to 10 carbon atoms, and R₃ and R₄ may bond to each other to form a ring), a compound having two or more epoxy groups, and a solvent.

As the composition for forming an antireflection organic resin layer and the composition for forming an organic resin layer, it is possible to use, for example, compositions described in WO 2006/115074. The entire disclosure of WO 2006/115074 is incorporated into the present application by reference.

Specifically, the compositions are, for example, a composition containing a polymer having a repeating unit structure represented by the following formula (1) or the following formula (2): 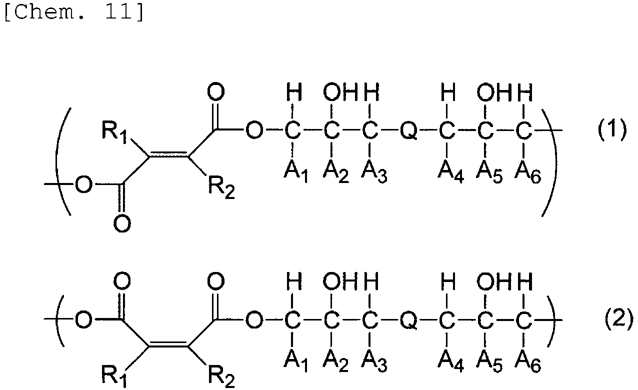 {in the formula, R₁ and R₂ each represent a hydrogen atom, a methyl group, an ethyl group, or a halogen atom, A₁, A₂, A₃, A₄, A₅, and A₆ each represent a hydrogen atom, a methyl group, or an ethyl group, Q represents a formula (3) or a formula (4): 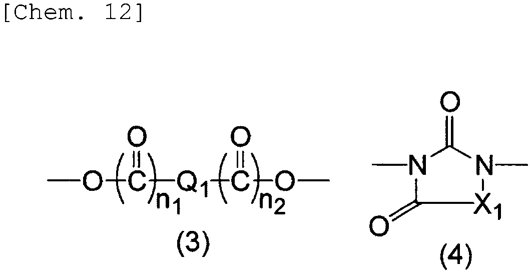 [in the formula, Q₁ represents an alkylene group having 1 to 15 carbon atoms, a phenyl group, a naphthylene group, or an anthrylene group, in addition, the phenyl group, the naphthylene group, and the anthrylene group may be each substituted with a group selected from a group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms, n₁ and n₂ each represents a number of 0 or 1, X₁ represents a formula (5) or (6) or a formula (7): 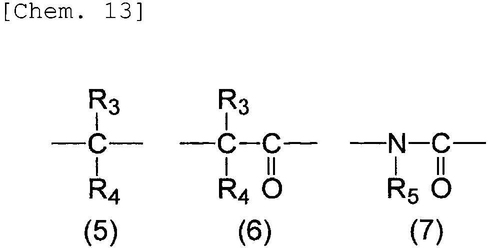 (in the formula, R₃ and R₄ may be each substituted with a group selected from the group consisting of a hydrogen atom, an alkyl group having 1 to 6 carbon atoms, an alkenyl group having 3 to 6 carbon atoms, a benzyl group, or a phenyl group, in addition, the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms, in addition, R₃ and R₄ may bond to each other to form a ring having 3 to 6 carbon atoms, R₅ represents an alkyl group having 1 to 6 carbon atoms, an alkenyl group having 3 to 6 carbon atoms, a benzyl group, or a phenyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxyl group, and an alkylthio group having 1 to 6 carbon atoms)]} and a solvent.

As the composition for forming an antireflection organic resin layer and the composition for forming an organic resin layer, it is possible to use, for example, compositions described in WO 2009/096340. The entire disclosure of WO 2009/096340 is incorporated into the present application by reference.

Specifically, the compositions are, for example, compositions containing a polymer having a disulfide bond in the main chain and a solvent.

In addition, specifically, the compositions are, for example, a composition containing a polymer having a repeating unit structure represented by the following formula (1'): 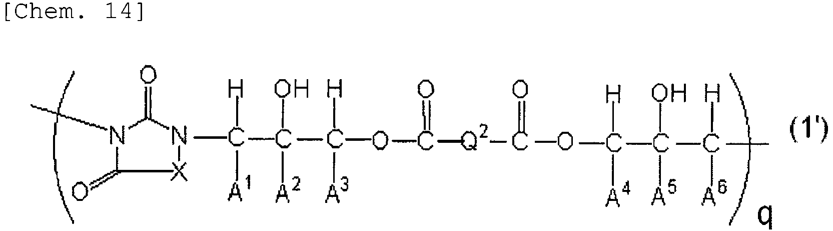 [in the formula, X represents a group represented by the following formula (2), formula (3), or formula (4): 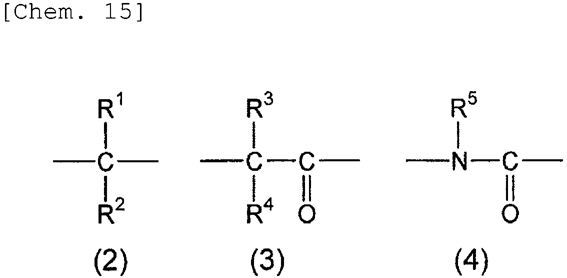 (in the above formula, R¹ to R⁵ each independently represent a hydrogen atom, an alkyl group having 1 to 6 carbon atoms, an alkenyl group having 3 to 6 carbon atoms, a benzyl group, or a phenyl group, the phenyl group may be substituted with at least one group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, and R¹ and R² and R³ and R⁴ may bond to each other to form a ring having 3 to 6 carbon atoms), A¹ to A⁶ each independently represent a hydrogen atom, a methyl group, or an ethyl group, Q² represents a divalent group having a sulfur atom, and q represents the number of repeating unit structures and an integer of 5 to 100] and a solvent.

As the composition for forming an antireflection organic resin layer and the composition for forming an organic resin layer, it is possible to use, for example, compositions described in WO 2009/104685. The entire disclosure of WO 2009/104685 is incorporated into the present application by reference.

Specifically, the compositions are, for example, a composition containing a polymer having a repeating structure represented by the following formula (1): 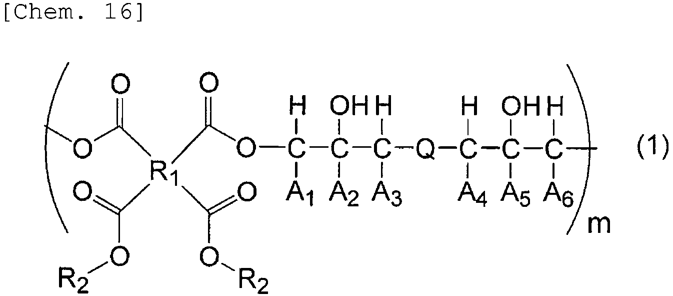 (in the formula, A₁, A₂, A₃, A₄, A₅, and A₆ each independently represent a hydrogen atom, a methyl group, or an ethyl group, Q represents a divalent organic group, R₁ represents an alicyclic structure or aliphatic structure having 4 to 20 carbon atoms, R₂ represents an alkyl group having 1 to 13 carbon atoms and having at least one group selected from the group consisting of an alkyl group having 1 to 13 carbon atoms, a cycloalkyl group having 3 to 13 carbon atoms, an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms, and an alkoxysulfonyl group having 1 to 13 carbon atoms as a substituent, and m represents the number of repeating units and is 5 to 300) and a solvent.

In addition, specifically, the compositions are, for example, a composition containing a polymer including a structural unit represented by the following formulae (28) and (29): 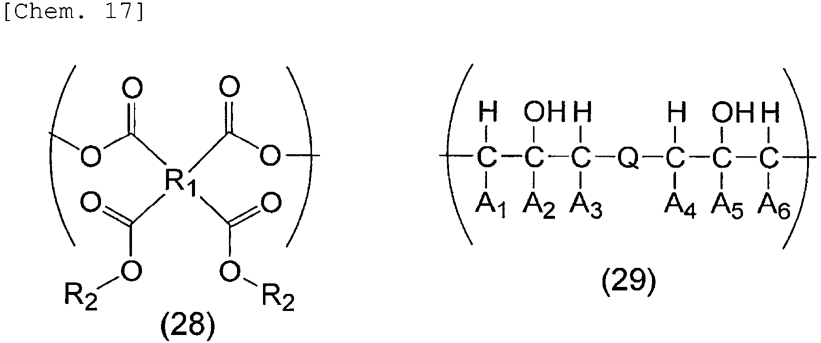 (in the formula (28), R₁ represents an alicyclic structure or aliphatic structure having 4 to 20 carbon atoms, and R₂ represents an alkyl group having 1 to 13 carbon atoms and having at least one group selected from the group consisting of an alkyl group having 1 to 13 carbon atoms, a cycloalkyl group having 3 to 13 carbon atoms, an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms, and an alkoxysulfonyl group having 1 to 13 carbon atoms as a substituent.

In the formula (29), A₁, A₂, A₃, A₄, A₅, and A₆ each independently represent a hydrogen atom, a methyl group, or an ethyl group, and Q represents a divalent organic group) and a solvent.

As the composition for forming an antireflection organic resin layer and the composition for forming an organic resin layer, it is possible to use, for example, compositions described in WO 2010/147155. The entire disclosure of WO 2010/147155 is incorporated into the present application by reference.

Specifically, the compositions are, for example, a composition containing a polymer including a unit structure represented by the following formula (1): 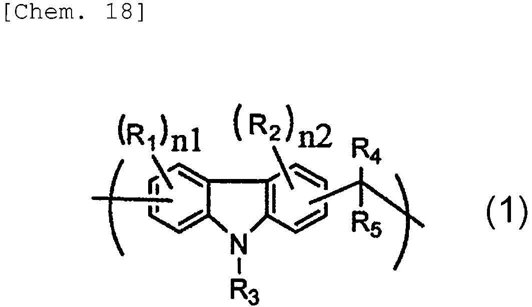
(in the formula (1), R₁ and R₂ each represent a group selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R₃ represents a group selected from the group consisting of a hydrogen atom, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R₄ represents an aryl group having 6 to 40 carbon atoms or a heterocyclic group that may have a halogen group, a nitro group, an amino group, or a hydroxy group as a substituent,
R₅ represents an alkyl group having 1 to 10 carbon atoms, an aryl group having 6 to 40 carbon atoms, or a heterocyclic group that may have a hydrogen atom, a halogen group, a nitro group, an amino group, or a hydroxy group as a substituent,
R₄ and R₅ may form a ring together with a carbon atom to which R₄ and R₅ bond, and
n1 and n2 are each an integer of 1 to 3).

In addition, specifically, the compositions are, for example, a composition containing a polymer including a unit structure represented by the following formula (2) and/or formula (3): 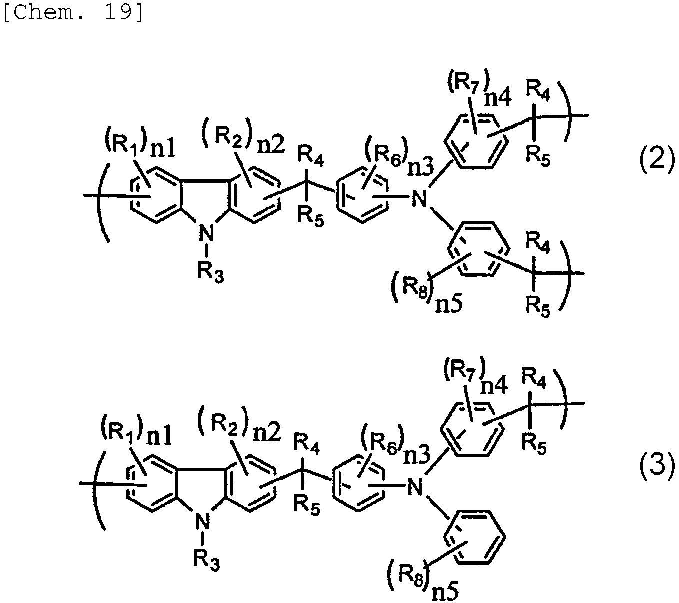
(in the formula (2) and the formula (3), R₁, R₂, R₆, R₇, and R₈ each represent a group selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R₃ represents a group selected from the group consisting of a hydrogen atom, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R₄ represents an aryl group having 6 to 40 carbon atoms or a heterocyclic group that may have a halogen group, a nitro group, an amino group, or a hydroxy group as a substituent,
R₅ represents an alkyl group having 1 to 10 carbon atoms, an aryl group having 6 to 40 carbon atoms, or a heterocyclic group that may have a hydrogen atom, a halogen group, a nitro group, an amino group, or a hydroxy group as a substituent,
R₄ and R₅ may form a ring together with a carbon atom to which R₄ and R₅ bond,
n1 and n2 are each an integer of 1 to 3, and
n3 to n5 are each an integer of 1 to 4).

As the composition for forming an antireflection organic resin layer and the composition for forming an organic resin layer, it is possible to use, for example, compositions described in WO 2013/047516. The entire disclosure of WO 2013/047516 is incorporated into the present application by reference.

Specifically, the compositions are, for example, a composition containing a polymer having a unit structure (A) represented by the following formula (1): 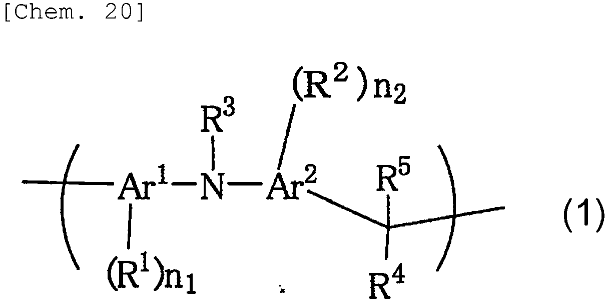
(in the formula (1), Ar¹ and Ar² each represent a benzene ring or a naphthalene ring, R¹ and R² each represent an organic group that is a substituent for a hydrogen atom on the ring as Ar¹ or Ar² and is selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R³ represents an organic group selected from the group consisting of a hydrogen atom, an alkyl group having 1 to 10 carbon atoms, an alkenyl group having 2 to 10 carbon atoms, an aryl group having 6 to 40 carbon atoms, and a combination thereof, the alkyl group, the alkenyl group, or the aryl group optionally containing an ether bond, a ketone bond, or an ester bond,
R⁴ represents an organic group selected from an aryl group having 6 to 40 carbon atoms or a heterocyclic group, the aryl group and the heterocyclic group optionally having a halogen group, a nitro group, an amino group, an alkyl group having 1 to 10 carbon atoms, an alkoxy group having 1 to 10 carbon atoms, an aryl group having 6 to 40 carbon atoms, a formyl group, a carboxyl group, or a hydroxyl group as a substituent,
R⁵ represents an organic group selected from an alkyl group having 1 to 10 carbon atoms, an aryl group having 6 to 40 carbon atoms, or a heterocyclic group, the alkyl group, the aryl group, and the heterocyclic group optionally having a halogen group, a nitro group, an amino group, or a hydroxyl group as a substituent, and R⁴ and R⁵ may form a ring together with a carbon atom to which R⁴ and R⁵ bond. n1 and n2 are each an integer of 0 to 3).

As the composition for forming an antireflection organic resin layer and the composition for forming an organic resin layer, it is possible to use, for example, compositions described in WO 2016/072316. The entire disclosure of WO 2016/072316 is incorporated into the present application by reference.

Specifically, the compositions are, for example, a composition containing a polymer having a unit structure represented by the following formula (1): 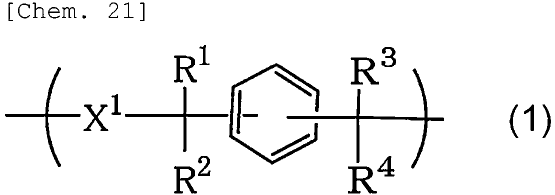 (in the formula (1), R¹ to R⁴ each independently represent a hydrogen atom or a methyl group. X¹ represents a divalent organic group containing at least one arylene group that may be substituted with an alkyl group, an amino group, or a hydroxyl group) and a solvent.

As the composition for forming an antireflection organic resin layer and the composition for forming an organic resin layer, it is possible to use, for example, compositions described in JP 2002-502982 W. The entire disclosure of JP 2002-502982 W is incorporated into the present application by reference.

Specifically, the compositions are, for example, an improved thermosetting composition containing
a. a reaction product between a high-molecular-weight acrylic polymer or copolymer and a deep UV light-absorbing carboxylic acid dye or phenolic dye, the reaction product having the polymer or copolymer to which the carboxylic acid dye bonds through a hydroxyester moiety or the phenolic dye bonds through a hydroxyether moiety, and the moiety being formed on the spot during a reaction,
b. an alkylated aminoplast crosslinking agent selected from the group consisting of melamine, urea, benzoguanamine, glycoluril, and a derivative thereof;
c. a protonic acid catalyst for curing, and
d. an alcohol-containing solvent system containing at least 20% of alcohol and having a low to medium boiling point, that is, 70°C to 80°C.

As the composition for forming an antireflection organic resin layer and the composition for forming an organic resin layer, it is possible to use, for example, compositions described in JP H11-511194 W. The entire disclosure of JP H11-511194 W is incorporated into the present application by reference.

Specifically, the compositions are, for example, an improved ARC composition containing
a. a dye-grafted hydroxyl-functional oligomer reaction product between a preselected phenol- or carboxylic acid-functional dye and a poly(epoxide) resin having an epoxy functionality of more than 2.0 and less than 10; the product having light-absorbing characteristics effective for ARC coating of a basal layer;
**b.** an alkylated aminoplast crosslinking agent derived from melamine, urea, benzoguanamine, or glycoluril;
**c.** a protonic acid curing catalyst; and
**d.** an alcohol-containing solvent system having a low to medium boiling point; in the solvent system, the alcohol occupying at least 20 (20) wt% of the total solvent content, and the molar ratio of the alcohol being at least 4 to 1 (4:1) per equivalent methylol unit of the aminoplast; and
**e.** an ether or ester bond derived from a poly(epoxide) molecule.

### <Composition for forming silicon-containing resin layer>

The composition for forming a silicon-containing resin layer that can be used in the present invention is not particularly limited, and for example, well-known compositions for forming a silicon-containing resin layer that are used in the lithography technique can be used.

These compositions contain, for example, a polysiloxane and a solvent. The compositions may further contain a crosslinking agent, a curing catalyst, or the **like.**

As the composition for forming a silicon-containing resin layer, it is possible to use, for example, compositions described in WO 2008/047715. The entire disclosure of WO 2008/047715 is incorporated into the present application by reference.

Specifically, the compositions are, for example, a silicon-containing hard mask forming composition. The silicon-containing hard mask forming composition contains a silicon-containing polymer, a crosslinking catalyst, and a solvent.

Examples of the silicon-containing polymer include polysilane, polysiloxane, polycarbosilane, or a combination thereof.

As the composition for forming a silicon-containing resin layer, it is possible to use, for example, compositions described in WO 2008/111463. The entire disclosure of WO 2008/111463 is incorporated into the present application by reference.

Specifically, the compositions are, for example, a film-forming coating liquid containing a polymer having a Si-O-Si bond and having a silanol group, an organic solvent represented by a formula R¹ (OCH₂CHCH₃)ₙOCOCH₃ (R¹ represents an alkyl group having 1 to 4 carbon atoms, and n represents 1 or 2), an organic solvent capable of dissolving a cis-type divalent carboxylic acid, and a cis-type divalent carboxylic acid.

Specifically, the compositions are, for example, a film-forming coating liquid containing a polymer having a Si-O-Si bond and having an organic group and a silanol group, an organic solvent represented by a formula R¹(OCH₂CHCH₃)ₙOCOCH₃ (R¹ represents an alkyl group having 1 to 4 carbon atoms, and n represents 1 or 2), an organic solvent capable of dissolving a cis-type divalent carboxylic acid, and a cis-type divalent carboxylic acid.

As the composition for forming a silicon-containing resin layer, it is possible to use, for example, compositions described in WO 2009/104552. The entire disclosure of WO 2009/104552 is incorporated into the present application by reference.

Specifically, the compositions are, for example, a composition containing a hydrolyzable organosilane, a hydrolysate thereof, or a hydrolysis condensate thereof as a silane, in which a silane having a cyclic amino group is present in a proportion of less than 1 mol% in the entire silane.

As the composition for forming a silicon-containing resin layer, it is possible to use, for example, compositions described in WO 2011/102470. The entire disclosure of WO 2011/102470 is incorporated into the present application by reference.

Specifically, the compositions are, for example, a lithography resist underlayer film-forming composition containing a hydrolyzable organosilane, a hydrolyzate thereof, or a hydrolysis condensate thereof as a silane compound, the composition containing,
as the hydrolyzable organosilane, a hydrolyzable organosilane represented by the following formula (1): 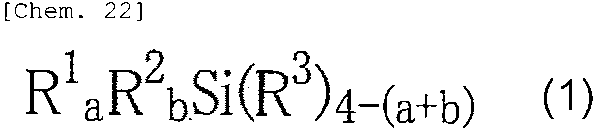 [in the formula, R¹ represents a formula (2): 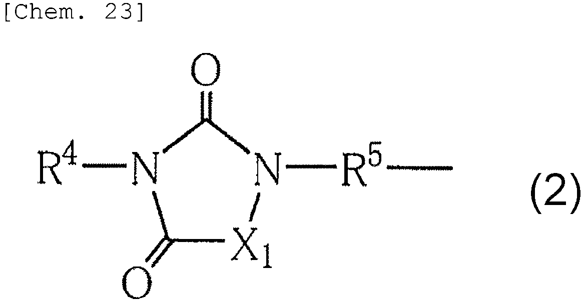 [in the formula (2), R⁴ represents a hydrogen atom, an alkyl group, alkenyl group, epoxy group, or sulfonyl group having 1 to 10 carbon atoms, or an organic group containing the above-described group, R⁵ represents an alkylene group having 1 to 10 carbon atoms, a hydroxyalkylene group, a sulfide bond, an ether bond, an ester bond, or a combination thereof, and X₁ represents a formula (3), a formula (4), or a formula (5): 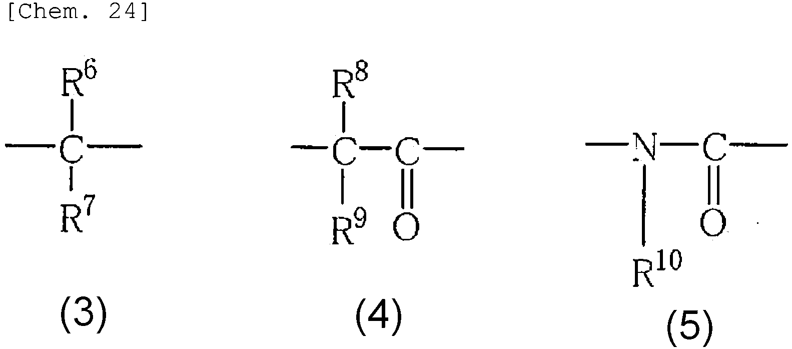
(in the formula (3), the formula (4), and the formula (5), R⁶ to R¹⁰ each independently represent a hydrogen atom, an alkyl group, alkenyl group, epoxy group, or sulfonyl group having 1 to 10 carbon atoms, or an organic group containing the above-described group) and bonds to a silicon atom by a Si-C bond, R² is an alkyl group, an aryl group, an aralkyl group, a halogenated alkyl group, a halogenated aryl group, a halogenated aralkyl group, an alkenyl group, an organic group having an epoxy group, an acryloyl group, a methacryloyl group, a mercapto group, an amino group, or a cyano group, or a combination thereof and bonds to a silicon atom by a Si-C bond, R³ represents an alkoxy group, an acyloxy group, or a halogen group. a represents an integer of 1, b represents an integer of 0 or 1, and a + b represents an integer of 1 or 2.]

As the composition for forming a silicon-containing resin layer, it is possible to use, for example, compositions described in WO 2010/021290. The entire disclosure of WO 2010/021290 is incorporated into the present application by reference.

Specifically, the compositions are, for example, a film-forming composition containing a silane compound having an onium group, the silane compound having an onium group being a hydrolyzable organosilane having an onium group in the molecule, a hydrolyzate thereof, or a hydrolysis condensate thereof.

In addition, specifically, the compositions are, for example, a lithography resist underlayer film-forming composition containing a silane compound having an onium group, the silane compound having an onium group being a hydrolyzable organosilane having an onium group in the molecule, a hydrolyzate thereof, or a hydrolysis condensate thereof.

### (Method for producing laminate)

A method for producing a laminate of the present invention includes, for example, a step of forming an antireflection organic resin layer by applying a composition for forming an antireflection organic resin layer.

A method for producing a laminate of the present invention includes, for example, a step of forming an organic resin layer by applying a composition for forming an organic resin layer.

A method for producing a laminate of the present invention includes, for example, a step of forming a silicon-containing resin layer by applying a composition for forming a silicon-containing resin layer.

Since layer that constitute the laminate can be formed by coating, the laminate and an optical diffractive body can be produced at low cost.

A coating method is not particularly limited, and examples thereof include methods in which an appropriate application device such as a spinner or a coater is used.

After the coating, heating (baking) is performed as necessary.

As the baking conditions at the time of forming the antireflection organic resin layer and the organic resin layer, the baking temperature and the baking time are appropriately selected from, for example, 80°C to 250°C and 0.3 to 60 minutes, respectively. Preferably, the baking temperature is 130°C to 250°C, and the baking time is 0.5 to 5 minutes.

As the baking conditions at the time of forming the silicon-containing resin layer, the baking temperature and the baking time are appropriately selected from, for example, 40°C to 400°C or 80°C to 250°C and 0.3 minutes to 60 minutes, respectively. Preferably, the baking temperature is 150°C to 250°C, and the baking time is 0.5 minutes to 2 minutes.

### (Method for producing optical diffractive body)

A method for producing an optical diffractive body of the present invention is a method for producing an optical diffractive body having a substrate and an optical diffraction grating layer disposed on the substrate and having a plurality of grooves using a photolithography or electron beam lithography technique.

A method for producing the optical diffractive body of the first aspect includes
a step of forming a resist film on the antireflection organic resin layer of the laminate of the first aspect,
a step of patterning the resist film by irradiating the resist film with light or an electron beam and developing the resist film,
a step of patterning the antireflection organic resin layer by etching using the patterned resist film as a mask, and
a step of etching the precursor layer using the patterned antireflection organic resin layer as a mask to form an optical diffraction grating layer having a plurality of grooves.

A method for producing the optical diffractive body of the second aspect includes
a step of forming a resist film on the antireflection organic resin layer of the laminate of the second aspect,
a step of patterning the resist film by irradiating the resist film with light or an electron beam and developing the resist film,
a step of patterning the inorganic mask layer and the antireflection organic resin layer by etching using the patterned resist film as a mask, and
a step of etching the precursor layer using the patterned inorganic mask layer as a mask to form an optical diffraction grating layer having a plurality of grooves.

A method for producing an optical diffractive body of the third aspect includes
a step of forming a resist film on the silicon-containing resin layer of the laminate of the third aspect,
a step of patterning the resist film by irradiating the resist film with light or an electron beam and developing the resist film,
a step of patterning the silicon-containing resin layer by etching using the patterned resist film as a mask,
a step of patterning the organic resin layer by etching using the patterned silicon-containing resin layer as a mask, and
a step of etching the precursor layer using the patterned organic resin layer as a mask to form an optical diffraction grating layer having a plurality of grooves.

A method for producing an optical diffractive body of the fourth aspect includes
a step of forming a resist film on the inorganic material layer of the laminate of the fourth aspect,
a step of patterning the resist film by irradiating the resist film with light or an electron beam and developing the resist film,
a step of patterning the inorganic material layer by etching using the patterned resist film as a mask,
a step of patterning the organic resin layer by etching using the patterned inorganic material layer as a mask, and
a step of etching the precursor layer using the patterned organic resin layer as a mask to form an optical diffraction grating layer having a plurality of grooves.

A method for producing an optical diffractive body of the fifth aspect includes
a step of forming a resist film on the antireflection organic resin layer of the laminate of the fifth aspect,
a step of patterning the resist film by irradiating the resist film with light or an electron beam and developing the resist film,
a step of patterning the inorganic material layer and the antireflection organic resin layer by etching using the patterned resist film as a mask,
a step of patterning the organic resin layer by etching using the patterned inorganic material layer as a mask, and
a step of etching the precursor layer using the patterned organic resin layer as a mask to form an optical diffraction grating layer having a plurality of grooves.

The plurality of grooves (trenches) in the optical diffraction grating layer may be grooves perpendicular to the surface of the optical diffraction grating layer or grooves at an angle to a perpendicular line to the surface of the optical diffraction grating layer. The angle of the groove with respect to the perpendicular line to the surface of the optical diffraction grating layer is not particularly limited.

The depths of the plurality of grooves in the optical diffraction grating layer may be the same as or different from each other.

The depths of the plurality of grooves in the optical diffraction grating layer are, for example, 100 nm to 1000 nm.

The intervals (pitches) between the plurality of grooves in the optical diffraction grating layer are, for example, 10 nm to 1000 nm.

### <Step of forming resist film>

A method for forming the resist film is not particularly limited, and the resist film is formed by a well-known method (for example, application and baking of a resist composition).

The resist film is not particularly limited as long as the resist film responds to light or an electron beam (EB) that is used for irradiation. Any of a negative photoresist and a positive photoresist can be used.

In the present specification, a resist that responds to EB is also sometimes referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used that include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878**,** JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition containing a resin A having a repeating unit having an acid-decomposable group in which a polar group is protected by a protecting group to be removed by an action of an acid, and a compound represented by general formula (121) below.

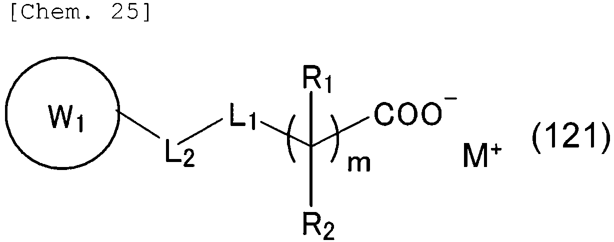

In general formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator.

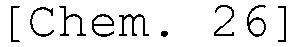

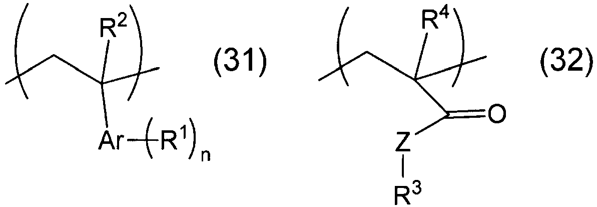

In formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid-unstable group, and that contains an acid generator. 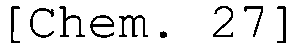 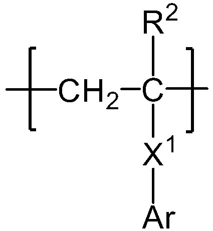 [in the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.]

Examples of the resist film include the following resist film.

A resist film including a base resin including a repeating unit represented by formula (a1) below and/or a repeating unit represented by formula (a2) below, and a repeating unit that generates an acid bonded to a polymer main chain by exposure. 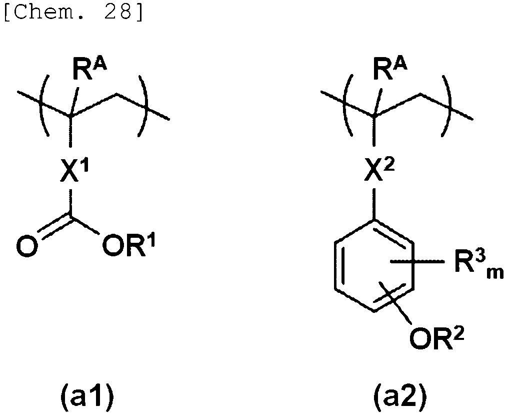 (in formula (a1) and formula (a2), R^{A}' s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.)

Examples of the resist material include the following resist material.

A resist material containing a polymer having a repeating unit represented by formula (b1) or formula (b2) below. 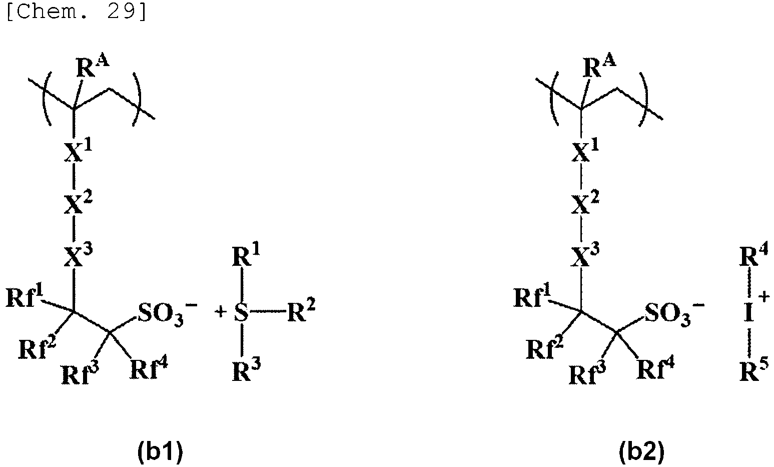 (in formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and R¹ and R² may be bonded to form a ring together with a sulfur atom to which R¹ and R² are bonded.)

A resist material containing a base resin including a polymer having a repeating unit represented by formula (a) below. 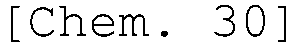 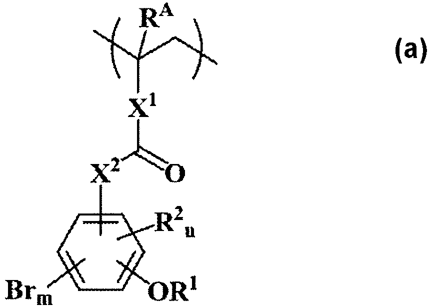 (in formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, u is an integer of 0 to 3, provided that m + u is an integer of 1 to 4.)

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by general formula (f2-r-1) below. 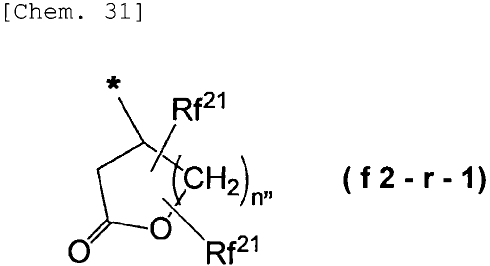
[in formula (f2-r-1), Rf²¹'s are each independently a hydrogen atom, an alkyl group, an alkoxy group, a hydroxy group, a hydroxyalkyl group, or a cyano group, n" is an integer of 0 to 2, and * is a bond.]

The constituent unit (f1) includes a constituent unit represented by general formula (f1-1) below or a constituent unit represented by general formula (f1-2) below. 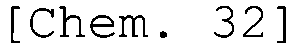 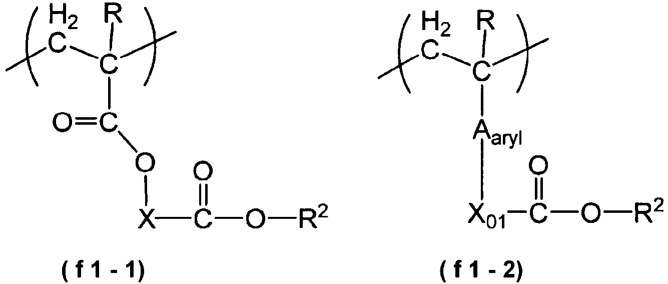 [in formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic cyclic group which may have a substituent, X₀₁ is a single bond or a divalent linking group, and R²'s are each independently an organic group having a fluorine atom.]

Examples of a coating, a coating solution, and a coating composition include the following.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))} (OH)ₓ (here, 0 < z ≤ 2 and 0 < (z + x) ≤ 4), the formula R'ₙSnX₄₋ₙ (here, n = 1 or 2), or a mixture thereof, wherein R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)} (OH)ₓ (wherein 0 < x < 3) wherein the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

The film thickness of the resist layer is, for example, 30,000 nm or less, 20,000 nm or less, 10,000 nm or less, 8,000 nm or less, or 5,000 nm or less. The lower limit is 100 nm, 80 nm, 50 nm, 30 nm, 20 nm, or 10 nm.

### <Step of patterning resist film>

In the step of patterning the resist film, the resist film is irradiated with light or an electron beam and developed.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali such as sodium hydroxide, potassium hydroxide, sodium carbonate, sodium silicate, sodium metasilicate, or ammonia water, a primary amine such as ethylamine or n-propylamine, a secondary amine such as diethylamine or di-n-butylamine, a tertiary amine such as triethylamine or methyldiethylamine, an alcoholamine such as dimethylethanolamine or triethanolamine, a quaternary ammonium salt such as tetramethylammonium hydroxide, tetraethylammonium hydroxide, or choline, or a cyclic amine such as pyrrole or piperidine can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferred, and an aqueous solution of tetramethylammonium hydroxide and an aqueous solution of choline are more preferred. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

Hereinafter, steps other than the step of forming a resist film and the step of patterning the resist film in the methods for producing an optical diffractive body according to the first aspect to the fifth aspects will be described.

### <First aspect: Step of patterning antireflection organic resin layer>

In the method for producing an optical diffractive body of the first aspect, a step of patterning an antireflection organic resin layer by etching using the patterned resist film as a mask is performed.

The etching of the antireflection organic resin layer may be dry etching or wet etching, but is preferably dry etching.

The etching is preferably performed by, for example, dry etching with an oxygen-based gas (an oxygen gas, an oxygen/carbonyl sulfide (COS) mixed gas, or the like).

### <First aspect: Step of forming optical diffraction grating layer having plurality of grooves>

In the method for producing an optical diffractive body of the first aspect, a step of etching a precursor layer using the patterned antireflection organic resin layer as a mask to form an optical diffraction grating layer having a plurality of grooves is performed.

In the step of forming the optical diffraction grating layer having the plurality of grooves of the first aspect, the precursor layer may be etched using the patterned resist film and the patterned antireflection organic resin layer as masks.

The etching of the precursor layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Second aspect: Step of patterning inorganic mask layer and antireflection organic resin layer>

In the method for producing an optical diffractive body of the second aspect, a step of patterning an inorganic mask layer and an antireflection organic resin layer by etching using the patterned resist film as a mask is performed.

The etching of the inorganic mask layer and the antireflection organic resin layer may be dry etching or wet etching, but is preferably dry etching.

The etching is preferably performed by, for example, dry etching with an oxygen-based gas (an oxygen gas, an oxygen/carbonyl sulfide (COS) mixed gas, or the like).

### <Second aspect: Step of forming optical diffraction grating layer having plurality of grooves>

In the method for producing an optical diffractive body of the second aspect, a step of etching a precursor layer using the patterned inorganic mask layer as a mask to form an optical diffraction grating layer having a plurality of grooves is performed.

The etching of the precursor layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Third aspect: Step of patterning silicon-containing resin layer>

In the method for producing an optical diffractive body of the third aspect, a step of patterning a silicon-containing resin layer by etching using the patterned resist film as a mask is performed.

The etching of the silicon-containing resin layer may be dry etching or wet etching, but is preferably dry etching.

In the dry etching, a halogen-based gas is preferably used. In the dry etching using the halogen-based gas, basically, it is difficult to remove a resist film made of an organic substance (photoresist film). In contrast, the silicon-containing resin layer containing a number of silicon atoms is rapidly removed with the halogen-based gas. Therefore, it is possible to suppress a decrease in the film thickness of the photoresist film resulting from the dry etching of the silicon-containing resin layer. In addition, as a result, it becomes possible to use the photoresist film in a thin film form. Therefore, the dry etching of the silicon-containing resin layer is preferably performed using a fluorine-containing gas, and examples of the fluorine-containing gas include, but are not limited to, tetrafluoromethane (CF₄), perfluorocyclobutane (C₄F₈), perfluoropropane (C₃F₈), trifluoromethane, and difluoromethane (CH₂F₂) .

### <Third aspect: Step of patterning organic resin layer>

In the method for producing an optical diffractive body of the third aspect, a step of patterning an organic resin layer by etching using the patterned silicon-containing resin layer as a mask is performed.

The etching of the organic resin layer may be dry etching or wet etching, but is preferably dry etching.

The etching is preferably performed by, for example, dry etching with an oxygen-based gas (an oxygen gas, an oxygen/carbonyl sulfide (COS) mixed gas, or the like).

### <Third aspect: Step of forming optical diffraction grating layer having plurality of grooves>

In the method for producing an optical diffractive body of the third aspect, a step of etching a precursor layer using the patterned organic resin layer as a mask to form an optical diffraction grating layer having a plurality of grooves is performed.

The etching of the precursor layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Fourth aspect: Step of patterning inorganic material layer>

In the method for producing an optical diffractive body of the fourth aspect, a step of patterning an inorganic material layer by etching using the patterned resist film as a mask is performed.

The etching of the inorganic material layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Fourth aspect: Step of patterning organic resin layer>

In the method for producing an optical diffractive body of the fourth aspect, a step of patterning an organic resin layer by etching using the patterned inorganic material layer as a mask is performed.

The etching of the organic resin layer may be dry etching or wet etching, but is preferably dry etching.

The etching is preferably performed by, for example, dry etching with an oxygen-based gas (an oxygen gas, an oxygen/carbonyl sulfide (COS) mixed gas, or the like).

### <Fourth aspect: Step of forming optical diffraction grating layer having plurality of grooves>

In the method for producing an optical diffractive body of the fourth aspect, a step of etching a precursor layer using the patterned organic resin layer as a mask to form an optical diffraction grating layer having a plurality of grooves is performed.

The etching of the precursor layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Fifth aspect: Step of patterning inorganic material layer and antireflection organic resin layer>

In the method for producing an optical diffractive body of the fifth aspect, a step of patterning an inorganic material layer and an antireflection organic resin layer by etching using the patterned resist film as a mask is performed.

The etching of the inorganic material layer and the antireflection organic resin layer may be dry etching or wet etching, but is preferably dry etching.

For example, it is preferable that the inorganic material layer is etched by dry etching with a fluorine-based gas (for example, tetrafluoromethane (CF₄), perfluorocyclobutane (C₄F₈), perfluoropropane (C₃F₈), trifluoromethane, difluoromethane (CH₂F₂), or the like) and the antireflection organic resin layer is etched by dry etching with an oxygen-based gas (an oxygen gas, an oxygen/carbonyl sulfide (COS) mixed gas, or the like).

### <Fifth aspect: Step of patterning organic resin layer>

In the method for producing an optical diffractive body of the fifth aspect, a step of patterning an organic resin layer by etching using the patterned inorganic material layer as a mask is performed.

The etching of the organic resin layer may be dry etching or wet etching, but is preferably dry etching.

The etching is preferably performed by, for example, dry etching with an oxygen-based gas (an oxygen gas, an oxygen/carbonyl sulfide (COS) mixed gas, or the like).

### <Fifth aspect: Step of forming optical diffraction grating layer having plurality of grooves>

In the method for producing an optical diffractive body of the fifth aspect, a step of etching a precursor layer using the patterned organic resin layer as a mask to form an optical diffraction grating layer having a plurality of grooves is performed.

The etching of the precursor layer may be dry etching or wet etching, but is preferably dry etching.

The etching is preferably performed by dry etching with a fluorine-based gas. Examples of the fluorine-based gas include tetrafluoromethane (CF₄), perfluorocyclobutane (C₄F₈), perfluoropropane (C₃F₈), trifluoromethane, and difluoromethane (CH₂F₂) .

### <Step of forming sacrificial layer>

The method for producing an optical diffractive body may further include a step of forming a sacrificial layer having an inclined thickness.

In the method for producing an optical diffractive body, the use of the sacrificial layer having the inclined thickness makes it possible to easily form a plurality of angled grooves in the optical diffraction grating layer.

The inclined thickness refers to a changing thickness in which the thickness becomes thicker or thinner in one end than in the other end.

The material of the sacrificial layer is not particularly limited, and examples thereof include organic resins. The sacrificial layer may be formed using, for example, a well-known resist material.

A method for forming the sacrificial layer having the inclined thickness is not particularly limited, and examples thereof include a method in which a sacrificial layer having a uniform thickness is formed, and a part of the sacrificial layer is then etched to incline the thickness. Examples of the etching include reactive ion etching (RIE) and the like.

Hereinafter, one example of the method for producing an optical diffractive body of the present invention will be described using the drawings.

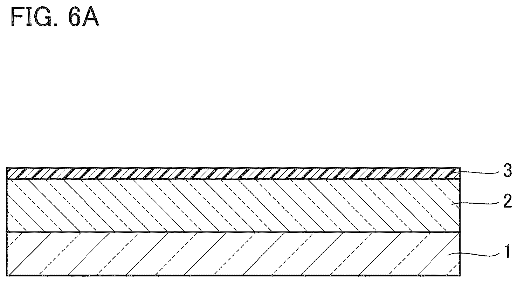

The method for producing an optical diffractive body shown in Fig. 6A to Fig. 6F is one example of the first aspect.

First, a laminate is prepared (Fig. 6A). The laminate shown in Fig. 6A is the laminate shown in Fig. 1. The laminate has a substrate 1, a precursor layer 2, and an antireflection organic resin layer 3. The precursor layer 2 is disposed on the substrate 1. The antireflection organic resin layer 3 is disposed on the precursor layer 2.

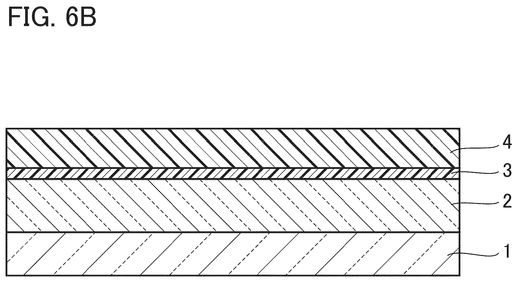

Next, a resist film 4 is formed on the antireflection organic resin layer 3 (Fig. 6B).

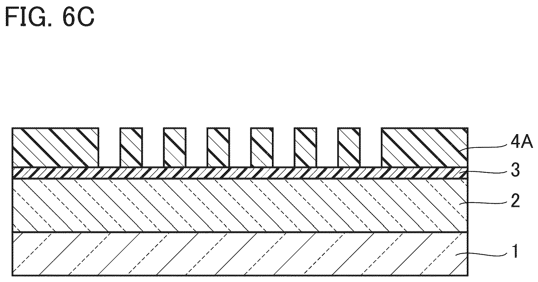

Next, the resist film 4 is irradiated with light or an electron beam and developed, whereby the resist film 4 is patterned (Fig. 6C). As a result, the patterned resist film 4A is obtained.

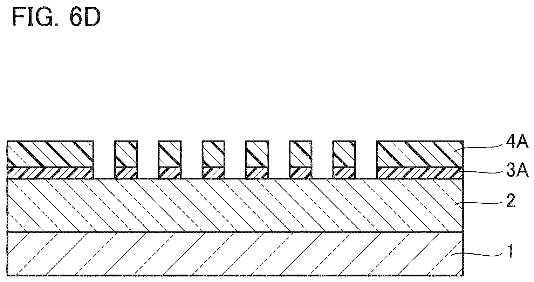

Next, the antireflection organic resin layer 3 is patterned by etching using the patterned resist film 4A as a mask (Fig. 6D). As a result, a patterned antireflection organic resin layer 3A is obtained.

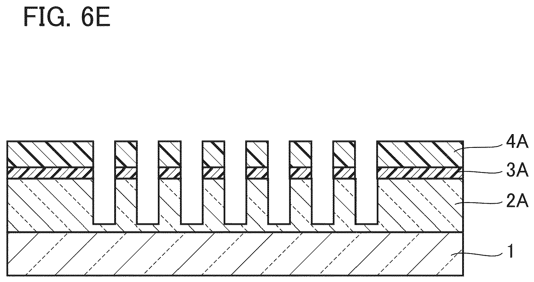

Next, the precursor layer 2 is etched using the patterned antireflection organic resin layer 3A as a mask to form an optical diffraction grating layer 2A having a plurality of grooves (Fig. 6E).

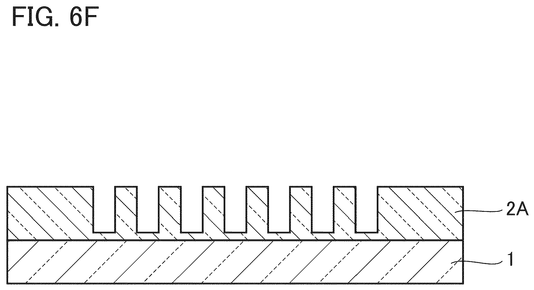

Next, the patterned resist film 4A and the patterned antireflection organic resin layer 3A are removed (Fig. 6F). The patterned resist film 4A and the patterned antireflection organic resin layer 3A can be removed by, for example, ashing.

One example of the optical diffractive body is thus obtained.

When the laminate has the antireflection organic resin layer 3, it is possible to prevent light or the electron beam that has permeated the resist film from being reflected by the substrate or the optical diffraction grating layer (the precursor layer) that configures the optical diffractive body, depending on a situation, a stage on which the substrate is placed, or the like, and returning to the resist film. When the reflection is prevented, it is possible to prevent abnormal exposure due to reflected light and to form a desired resist pattern (for example, a resist pattern having a cross section controlled to be a rectangular shape). As a result, lithographic characteristics improve, and a desired optical diffraction grating layer can be easily fabricated with high accuracy.

In the methods for producing an optical diffractive body shown in Fig. 6A to Fig. 6F, when the optical diffraction grating layer 2A having a plurality of grooves is formed, aside from the patterned antireflection organic resin layer 3A, the patterned resist film 4A also functions as a mask, but the mask may be only the patterned antireflection organic resin layer 3A. For example, the patterned resist film 4A may be removed after the patterned antireflection organic resin layer 3A is obtained.

In addition, in the method for producing an optical diffractive body shown in Fig. 6A to Fig. 6F, the grooves perpendicular to the surface of the optical diffraction grating layer 2A are formed; however, for example, grooves at an angle with respect to a perpendicular line to the surface of the optical diffraction grating layer 2A may also be formed.

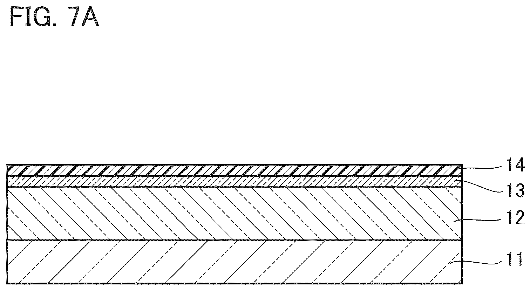

The method for producing an optical diffractive body shown in Fig. 7A to Fig. 7H is one example of the second aspect.

First, a laminate is prepared (Fig. 7A). The laminate shown in Fig. 7A is the laminate shown in Fig. 2. The laminate has a substrate 11, a precursor layer 12, an inorganic mask layer 13, and an antireflection organic resin layer 14. The precursor layer 12 is disposed on the substrate 11. The inorganic mask layer 13 is disposed on the precursor layer 12. The antireflection organic resin layer 14 is disposed on the inorganic mask layer 13.

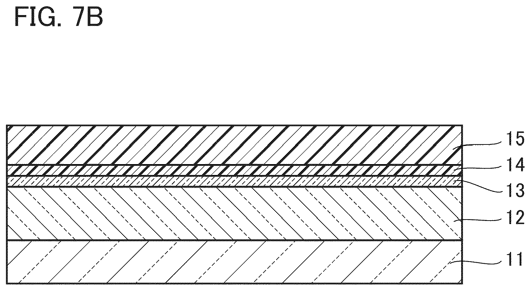

Next, a resist film 15 is formed on the antireflection organic resin layer 14 (Fig. 7B).

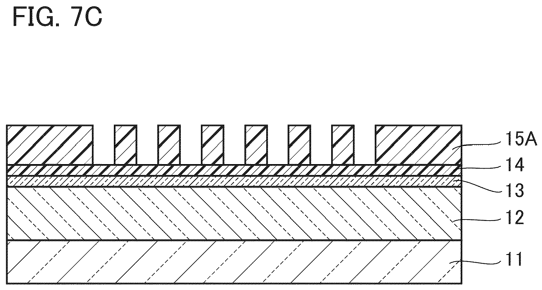

Next, the resist film 15 is irradiated with light or an electron beam and developed, whereby the resist film 15 is patterned (Fig. 7C). As a result, the patterned resist film 15A is obtained.

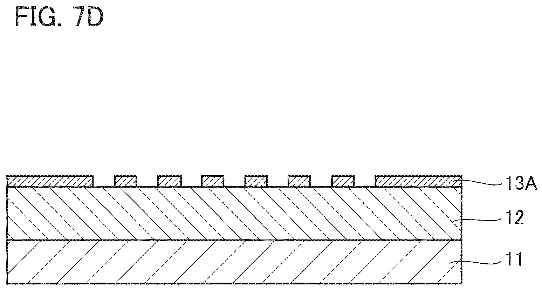

Next, the inorganic mask layer 13 and the antireflection organic resin layer 14 are patterned by etching using the patterned resist film 15A as a mask (Fig. 7D). As a result, a patterned inorganic mask layer 13A is obtained.

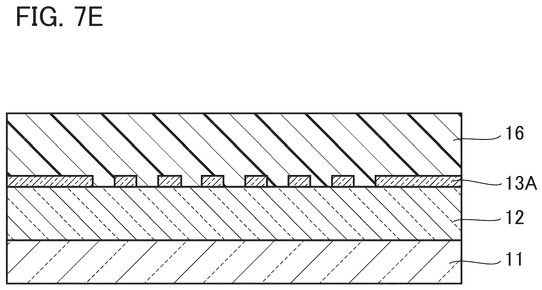

Next, a sacrificial layer 16 is formed on the patterned inorganic mask layer 13A and the exposed precursor layer 12 (Fig. 7E).

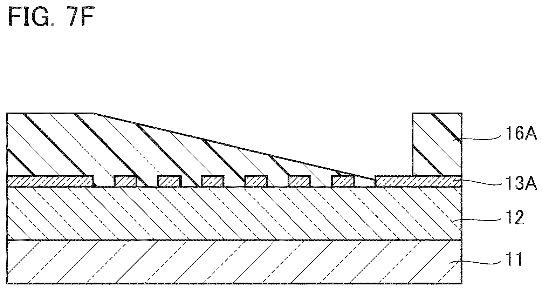

Next, the sacrificial layer 16 is etched to form a sacrificial layer 16A having an inclined thickness (Fig. 7F).

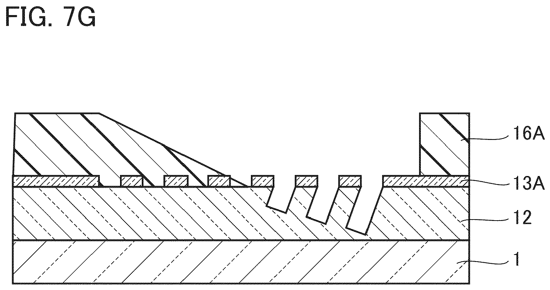

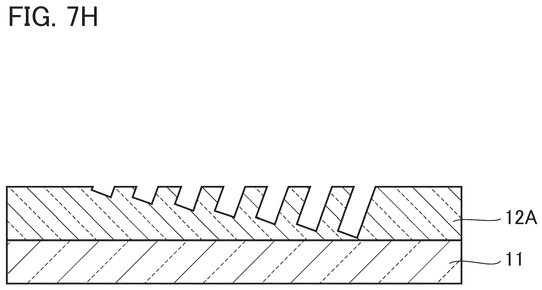

Next, the precursor layer 12 is etched using the patterned inorganic mask layer 13A as a mask to form an optical diffraction grating layer 12A having a plurality of grooves (Fig. 7G and Fig. 7H). At this time, the etching is performed so as to form grooves at an angle with respect to a perpendicular line to the surface of the optical diffraction grating layer 12A. The etching is, for example, angled ion etching. The angled ion etching is performed by, for example, a reactive ion beam.

Next, the remaining patterned inorganic mask layer 13A and the remaining sacrificial layer 16A having an inclined thickness are removed (Fig. 7H).

One example of the optical diffractive body is thus obtained.

When the laminate has the antireflection organic resin layer 14, it is possible to prevent light or the electron beam that has permeated the resist film from being reflected by the substrate or the optical diffraction grating layer (the precursor layer) that configures the optical diffractive body, depending on a situation, a stage on which the substrate is placed, or the like, and returning to the resist film. When the reflection is prevented, it is possible to prevent abnormal exposure due to reflected light and to form a desired resist pattern. As a result, lithographic characteristics improve, and a desired optical diffraction grating layer can be easily fabricated with high accuracy.

In addition, the joint use of the inorganic mask layer 13 more highly resistant to etching than the antireflection organic resin layer 14 with the antireflection organic resin layer 14 makes it possible to easily fabricate a desired optical diffraction grating layer with higher accuracy.

In addition, in the method for producing an optical diffractive body shown in Fig. 7A to Fig. 7H, the grooves at an angle to a perpendicular line to the surface of the optical diffraction grating layer 12A are formed, but grooves perpendicular to the surface of the optical diffraction grating layer 12A may also be formed. For example, the optical diffraction grating layer 12A having a plurality of grooves perpendicular to the surface may be formed by etching the precursor layer 12 using the patterned inorganic mask layer 13A as a mask in the laminate shown in Fig. 7D.

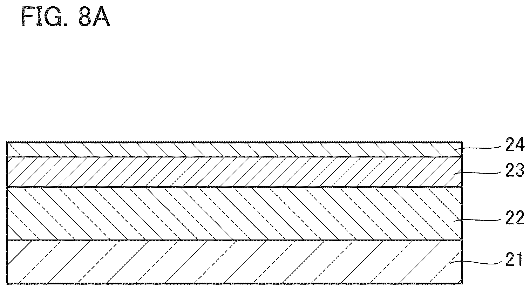

The method for producing an optical diffractive body shown in Fig. 8A to Fig. 8I is one example of the third aspect.

First, a laminate is prepared (Fig. 8A). The laminate shown in Fig. 8A is the laminate shown in Fig. 3. The laminate has a substrate 21, a precursor layer 22, an organic resin layer 23, and a silicon-containing resin layer 24. The precursor layer 22 is disposed on the substrate 21. The organic resin layer 23 is disposed on the precursor layer 22. The silicon-containing resin layer 24 is disposed on the organic resin layer 23.

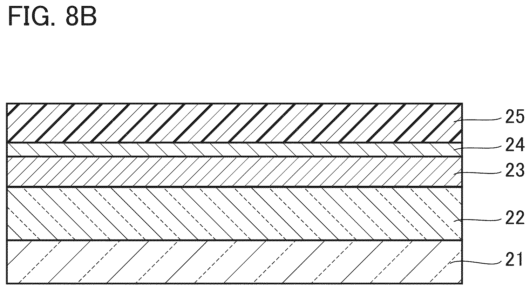

Next, a resist film 25 is formed on the silicon-containing resin layer 24 (Fig. 8B).

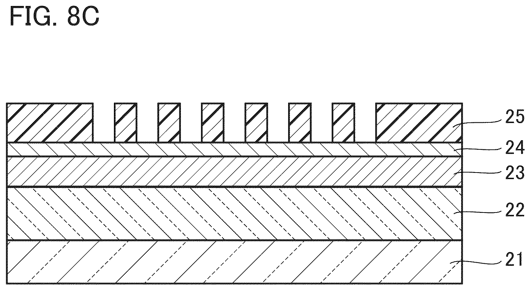

Next, the resist film 25 is irradiated with light or an electron beam and developed, whereby the resist film 25 is patterned (Fig. 8C). As a result, the patterned resist film 25A is obtained.

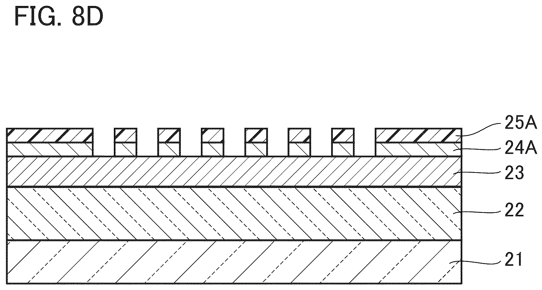

Next, the silicon-containing resin layer 24 is patterned by etching using the patterned resist film 25A as a mask (Fig. 8D). As a result, a patterned silicon-containing resin layer 24A is obtained.

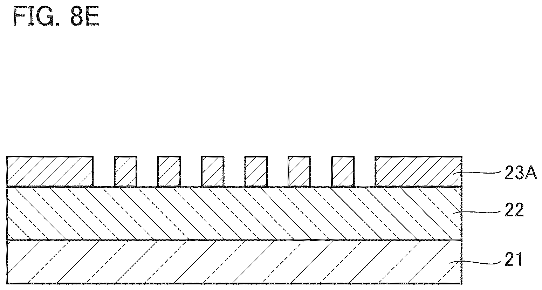

Next, the organic resin layer 23 is patterned by etching using the patterned silicon-containing resin layer 24A as a mask (Fig. 8E). As a result, a patterned organic resin layer 23A is obtained.

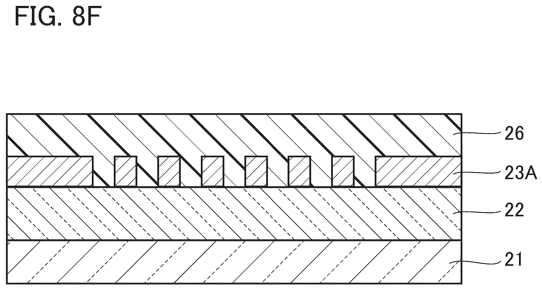

Next, a sacrificial layer 26 is formed on the patterned organic resin layer 23A and the exposed precursor layer 22 (Fig. 8F).

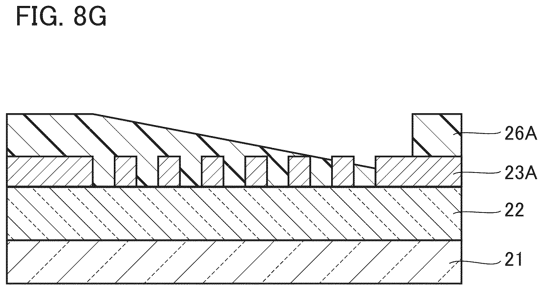

Next, the sacrificial layer 26 is etched to form a sacrificial layer 26A having an inclined thickness (Fig. 8G).

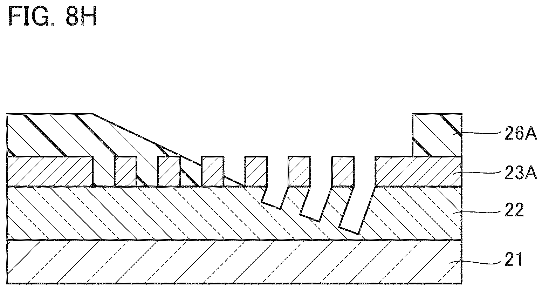

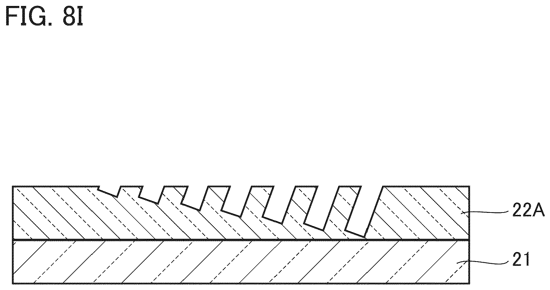

Next, the precursor layer 22 is etched using the patterned organic resin layer 23A as a mask to form an optical diffraction grating layer 22A having a plurality of grooves (Fig. 8H and Fig. 8I). At this time, the etching is performed so as to form grooves at an angle with respect to a perpendicular line to the surface of the optical diffraction grating layer 22A. The etching is, for example, angled ion etching. The angled ion etching is performed by, for example, a reactive ion beam.

Next, the remaining patterned organic resin layer 23A and the remaining sacrificial layer 26A having an inclined thickness are removed (Fig. 8I).

One example of the optical diffractive body is thus obtained.

In the case of producing an optical diffractive body using the lithography technique, there is a problem in that as a groove that is formed in an optical diffraction grating layer becomes finer, it becomes more difficult to form a deep groove in the optical diffraction grating layer. This is because when a resist film thick enough to have sufficient mask performance for the formation of a deep groove is used, a resist pattern is more likely to collapse as the groove becomes finer.

Therefore, the laminate that is used in the third aspect has the organic resin layer 23 and the silicon-containing resin layer 24. Since the organic resin layer 23 can be made thick, it is possible to form a deep groove in the optical diffraction grating layer 22A using the patterned organic resin layer 23 having a high aspect ratio as a mask. Therefore, at the time of producing an optical diffractive body using the lithography technique, it is possible to easily make a groove that is formed in an optical diffraction grating layer thick.

In addition, since modification of a layer (for example, introduction of a functional group or the like, a change in density of the layer, or the like) is easier in the silicon-containing resin layer 24 than in the inorganic material layer 34 to be described below, it is easy to modify the characteristics (for example, hydrophilicity and hydrophobicity) of the layer. As a result, it becomes easy to improve the adhesion with a resist film, which will be an upper layer, or to further improve the lithographic characteristics (for example, sensitivity) of the resist film.

In the methods for producing an optical diffractive body shown in Fig. 8A to Fig. 8I, when the patterned organic resin layer 23A is formed, aside from the patterned silicon-containing resin layer 24A, the patterned resist film 25A also functions as a mask, but the mask may be only the patterned silicon-containing resin layer 24A. For example, the patterned resist film 25A may be removed after the patterned silicon-containing resin layer 24A is obtained.

In addition, in the method for producing an optical diffractive body shown in Fig. 8A to Fig. 8I, the grooves at an angle to a perpendicular line to the surface of the optical diffraction grating layer 22A are formed, but grooves perpendicular to the surface of the optical diffraction grating layer 22A may also be formed. For example, the optical diffraction grating layer 22A having a plurality of grooves perpendicular to the surface may be formed by etching the precursor layer 22 using the patterned organic resin layer 23A as a mask in the laminate shown in Fig. 8E.

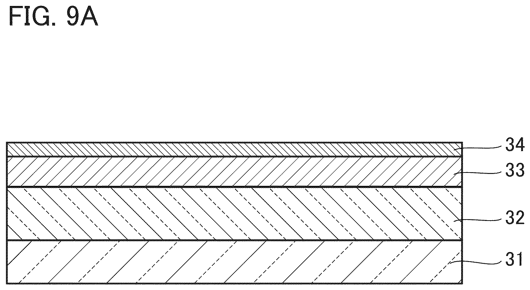

The method for producing an optical diffractive body shown in Fig. 9A to Fig. 9I is one example of the fourth aspect.

First, a laminate is prepared (Fig. 9A). The laminate shown in Fig. 9A is the laminate shown in Fig. 4. The laminate has the substrate 31, the precursor layer 32, the organic resin layer 33, and the inorganic material layer 34. The precursor layer 32 is disposed on the substrate 31. The organic resin layer 33 is disposed on the precursor layer 32. The inorganic material layer 34 is disposed on the organic resin layer 33.

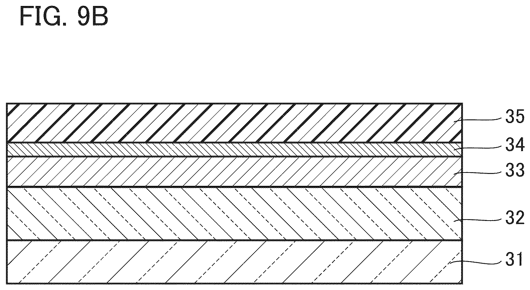

Next, a resist film 35 is formed on the inorganic material layer 34 (Fig. 9B).

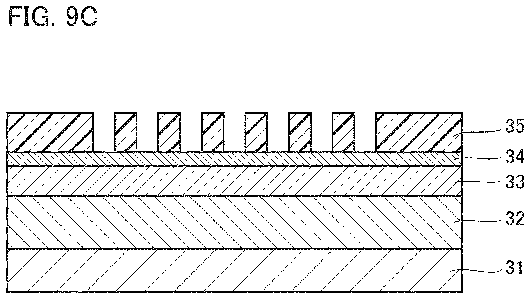

Next, the resist film 35 is irradiated with light or an electron beam and developed, whereby the resist film 35 is patterned (Fig. 9C). As a result, the patterned resist film 35A is obtained.

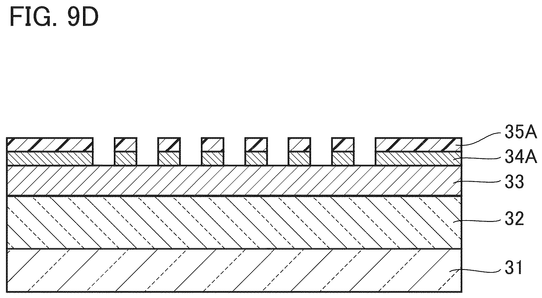

Next, the inorganic material layer 34 is patterned by etching using the patterned resist film 35A as a mask (Fig. 9D). As a result, a patterned inorganic material layer 34A is obtained.

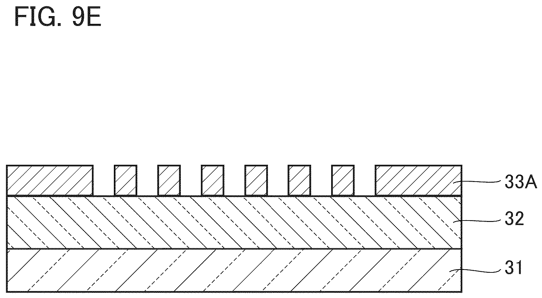

Next, the organic resin layer 33 is patterned by etching using the patterned inorganic material layer 34A as a mask (Fig. 9E). As a result, a patterned organic resin layer 33A is obtained.

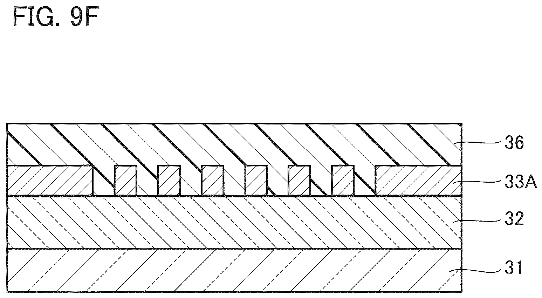

Next, a sacrificial layer 36 is formed on the patterned organic resin layer 33A and the exposed precursor layer 32 (Fig. 9F).

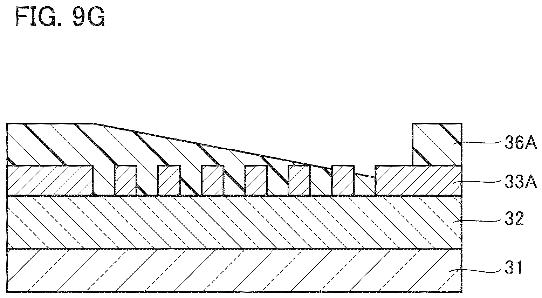

Next, the sacrificial layer 36 is etched to form a sacrificial layer 36A having an inclined thickness (Fig. 9G).

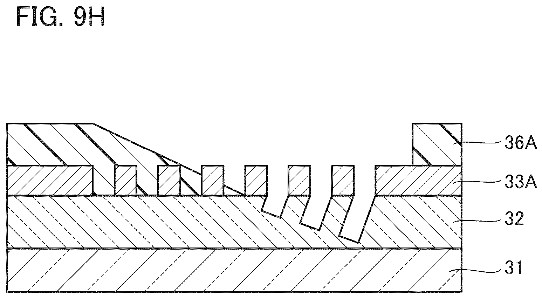

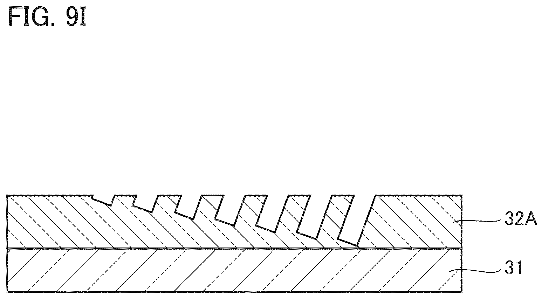

Next, the precursor layer 32 is etched using the patterned organic resin layer 33A as a mask to form an optical diffraction grating layer 32A having a plurality of grooves (Fig. 9H and Fig. 9I). At this time, the etching is performed so as to form grooves at an angle with respect to a perpendicular line to the surface of the optical diffraction grating layer 32A. The etching is, for example, angled ion etching. The angled ion etching is performed by, for example, a reactive ion beam.

Next, the remaining patterned organic resin layer 33A and the remaining sacrificial layer 36A having an inclined thickness are removed (Fig. 9I).

One example of the optical diffractive body is thus obtained.

In the case of producing an optical diffractive body using the lithography technique, there is a problem in that as a groove that is formed in an optical diffraction grating layer becomes finer, it becomes more difficult to form a deep groove in the optical diffraction grating layer. This is because when a resist film thick enough to have sufficient mask performance for the formation of a deep groove is used, a resist pattern is more likely to collapse as the groove becomes finer.

Therefore, the laminate that is used in the fourth aspect has the organic resin layer 33 and the inorganic material layer 34. Since the organic resin layer 33 can be made thick, it is possible to form a deep groove in the optical diffraction grating layer 32A using the patterned organic resin layer 33 having a high aspect ratio as a mask. Therefore, at the time of producing an optical diffractive body using the lithography technique, it is possible to easily make a groove that is formed in an optical diffraction grating layer thick.

In the method for producing an optical diffractive body shown in Fig. 9A to Fig. 9I, when the patterned organic resin layer 33A is formed, aside from the patterned inorganic material layer 34A, the patterned resist film 35A also functions as a mask, but the mask may be only the patterned inorganic material layer 34A. For example, the patterned resist film 35A may be removed after the patterned inorganic material layer 34A is obtained.

In addition, in the method for producing an optical diffractive body shown in Fig. 9A to Fig. 9I, the grooves at an angle to a perpendicular line to the surface of the optical diffraction grating layer 32A are formed, but grooves perpendicular to the surface of the optical diffraction grating layer 32A may also be formed. For example, the optical diffraction grating layer 32A having a plurality of grooves perpendicular to the surface may be formed by etching the precursor layer 32 using the patterned organic resin layer 33A as a mask in the laminate shown in Fig. 9E.

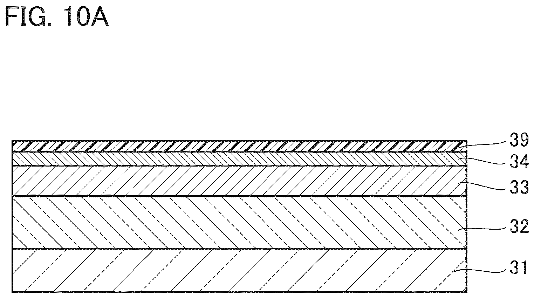

The method for producing an optical diffractive body shown in Fig. 10A to Fig. 10I is one example of the fifth aspect.

First, a laminate is prepared (Fig. 10A). The laminate shown in Fig. 10A is the laminate shown in Fig. 5. The laminate has the substrate 31, the precursor layer 32, the organic resin layer 33, the inorganic material layer 34, and an antireflection organic resin layer 39. The precursor layer 32 is disposed on the substrate 31. The organic resin layer 33 is disposed on the precursor layer 32. The inorganic material layer 34 is disposed on the organic resin layer 33. The antireflection organic resin layer 39 is disposed on the inorganic material layer 34.

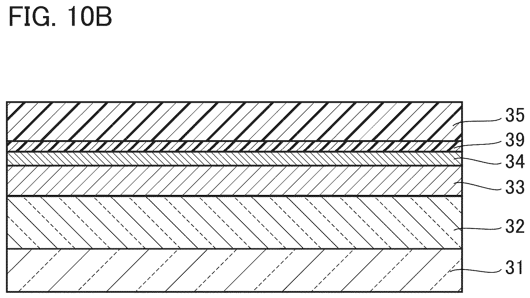

Subsequently, a resist film 35 is formed on the inorganic material layer 34 (Fig. 10B).

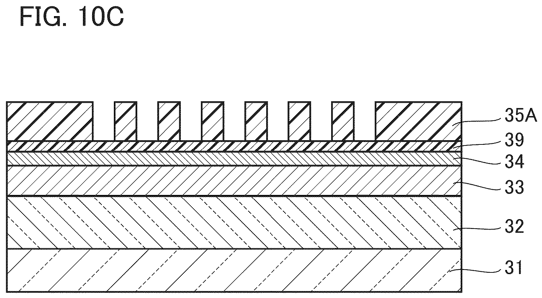

Next, the resist film 35 is irradiated with light or an electron beam and developed, whereby the resist film 35 is patterned (Fig. 10C). As a result, the patterned resist film 35A is obtained.

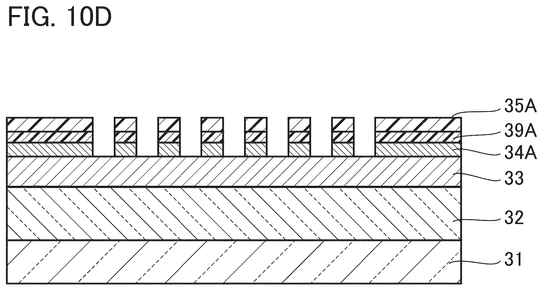

Next, the inorganic material layer 34 and the antireflection organic resin layer 39 are patterned by etching using the patterned resist film 35A as a mask (Fig. 10D). As a result, a patterned inorganic material layer 34A and a patterned antireflection organic resin layer 39A are obtained.

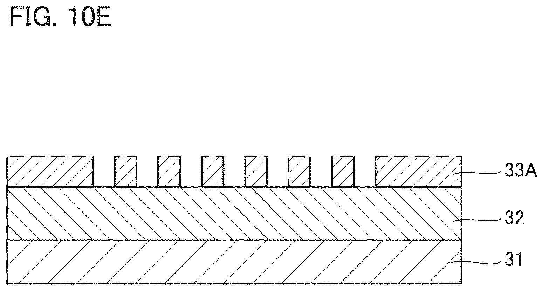

Next, the organic resin layer 33 is patterned by etching using the patterned inorganic material layer 34A as a mask (Fig. 10E). As a result, a patterned organic resin layer 33A is obtained.

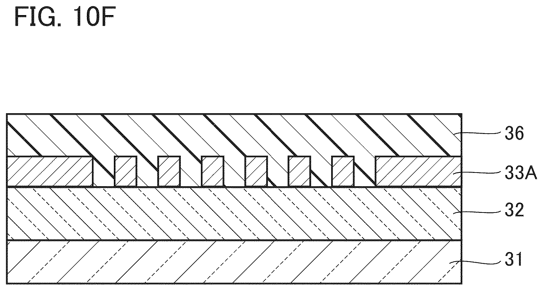

Next, a sacrificial layer 36 is formed on the patterned organic resin layer 33A and the exposed precursor layer 32 (Fig. 10F).

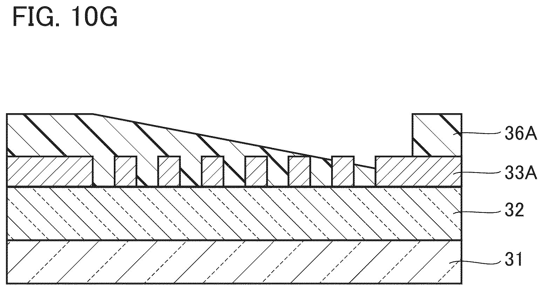

Next, the sacrificial layer 36 is etched to form a sacrificial layer 36A having an inclined thickness (Fig. 10G).

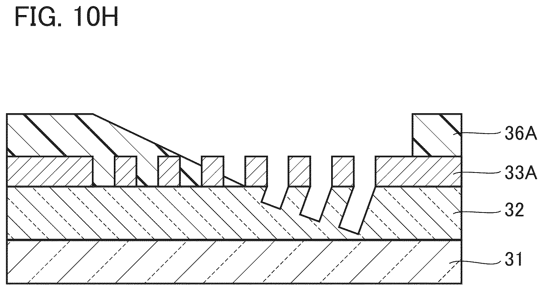

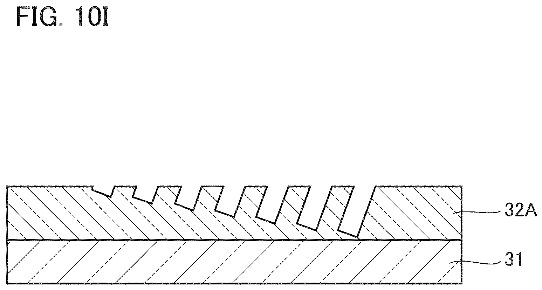

Next, the precursor layer 32 is etched using the patterned organic resin layer 33A as a mask to form an optical diffraction grating layer 32A having a plurality of grooves (Fig. 10H and Fig. 10I). At this time, the etching is performed so as to form grooves at an angle with respect to a perpendicular line to the surface of the optical diffraction grating layer 32A. The etching is, for example, angled ion etching. The angled ion etching is performed by, for example, a reactive ion beam.

Next, the remaining patterned organic resin layer 33A and the remaining sacrificial layer 36A having an inclined thickness are removed (Fig. 10I).

One example of the optical diffractive body is thus obtained.

In the case of producing an optical diffractive body using the lithography technique, there is a problem in that as a groove that is formed in an optical diffraction grating layer becomes finer, it becomes more difficult to form a deep groove in the optical diffraction grating layer. This is because when a resist film thick enough to have sufficient mask performance for the formation of a deep groove is used, a resist pattern is more likely to collapse as the groove becomes finer.

Therefore, the laminate that is used in the fifth aspect has the organic resin layer 33 and the inorganic material layer 34. Since the organic resin layer 33 can be made thick, it is possible to form a deep groove in the optical diffraction grating layer 32A using the patterned organic resin layer 33 having a high aspect ratio as a mask. Therefore, at the time of producing an optical diffractive body using the lithography technique, it is possible to easily make a groove that is formed in an optical diffraction grating layer thick.

In addition, the laminate has the antireflection organic resin layer 39, whereby a desired resist pattern can be formed at the time of producing an optical diffractive body using the lithography technique. As a result, lithographic characteristics improve, and a desired optical diffraction grating layer can be easily fabricated with high accuracy.

In the methods for producing an optical diffractive body shown in Fig. 10A to Fig. 10I, when the patterned organic resin layer 33A is formed, aside from the patterned inorganic material layer 34A, the patterned resist film 35A also functions as a mask, but the mask may be only the patterned inorganic material layer 34A. For example, the patterned resist film 35A may be removed after the patterned inorganic material layer 34A is obtained.

In addition, in the method for producing an optical diffractive body shown in Fig. 10A to Fig. 10I, the grooves at an angle to a perpendicular line to the surface of the optical diffraction grating layer 32A are formed, but grooves perpendicular to the surface of the optical diffraction grating layer 32A may also be formed. For example, the optical diffraction grating layer 32A having a plurality of grooves perpendicular to the surface may be formed by etching the precursor layer 32 using the patterned organic resin layer 33A as a mask in the laminate shown in Fig. 10E.

### Reference Signs List

- 1: Substrate
- 2: Precursor layer
- 2A: Optical diffraction grating layer
- 3: Antireflection organic resin layer
- 3A: Patterned antireflection organic resin layer
- 4: Resist film
- 4A: Patterned resist film
- 11: Substrate
- 12: Precursor layer
- 12A: Optical diffraction grating layer
- 13: Inorganic mask layer
- 13A: Patterned inorganic mask layer
- 14: Antireflection organic resin layer
- 14A: Patterned antireflection organic resin layer
- 15: Resist film
- 15A: Patterned resist film
- 16: Sacrificial layer

- 16A: Sacrificial layer having inclined thickness
- 21: Substrate
- 22: Precursor layer
- 22A: Optical diffraction grating layer
- 23: Organic resin layer
- 23A: Patterned antireflection organic resin layer
- 24: Silicon-containing resin layer
- 24A: Patterned silicon-containing resin layer
- 25: Resist film
- 25A: Patterned resist film
- 26: Sacrificial layer
- 26A: Sacrificial layer having inclined thickness
- 31: Substrate
- 32: Precursor layer
- 32A: Optical diffraction grating layer
- 33: Organic resin layer
- 33A: Patterned antireflection organic resin layer
- 34: Inorganic material layer
- 34A: Patterned antireflection inorganic material layer
- 35: Resist film
- 35A: Patterned resist film
- 36: Sacrificial layer
- 36A: Sacrificial layer having inclined thickness
- 39: Antireflection organic resin layer
- 39A: Patterned antireflection organic resin layer

## Claims

1. A laminate for producing an optical diffractive body having a substrate and an optical diffraction grating layer disposed on the substrate and having a plurality of grooves using a photolithography or electron beam lithography technique, the laminate comprising:
the substrate;
a precursor layer that becomes the optical diffraction grating layer by being disposed on the substrate and forming the plurality of grooves therein; and
an antireflection organic resin layer disposed on the precursor layer.

2. A laminate for producing an optical diffractive body having a substrate and an optical diffraction grating layer disposed on the substrate and having a plurality of grooves using a photolithography or electron beam lithography technique, the laminate comprising:
the substrate;
a precursor layer that becomes the optical diffraction grating layer by being disposed on the substrate and forming the plurality of grooves therein;
an inorganic mask layer disposed on the precursor layer; and
an antireflection organic resin layer disposed on the inorganic mask layer.

3. A laminate for producing an optical diffractive body having a substrate and an optical diffraction grating layer disposed on the substrate and having a plurality of grooves using a photolithography or electron beam lithography technique, the laminate comprising:
the substrate;
a precursor layer that becomes the optical diffraction grating layer by being disposed on the substrate and forming the plurality of grooves therein;
an organic resin layer disposed on the precursor layer; and
a silicon-containing resin layer disposed on the organic resin layer.

4. A laminate for producing an optical diffractive body having a substrate and an optical diffraction grating layer disposed on the substrate and having a plurality of grooves using a photolithography or electron beam lithography technique, the laminate comprising:
the substrate;
a precursor layer that becomes the optical diffraction grating layer by being disposed on the substrate and forming the plurality of grooves therein;
an organic resin layer disposed on the precursor layer; and
an inorganic material layer disposed on the organic resin layer.

5. The laminate according to claim 4, further comprising: an antireflection organic resin layer disposed on the inorganic material layer.

6. A composition for forming an antireflection organic resin layer that is used to form the antireflection organic resin layer in the laminate according to claim 1, 2, or 5 by coating.

7. A composition for forming an organic resin layer that is used to form the organic resin layer in the laminate according to any one of claims 3 to 5 by coating.

8. A composition for forming a silicon-containing resin layer that is used to form the silicon-containing resin layer in the laminate according to claim 3 by coating.

9. A method for producing a laminate for producing the laminate according to claim 1, 2, or 5, the method comprising:
a step of forming an antireflection organic resin layer by applying a composition for forming an antireflection organic resin layer.

10. A method for producing a laminate for producing the laminate according to any one of claims 3 to 5, the method comprising:
a step of forming the organic resin layer by applying a composition for forming an organic resin layer.

11. A method for producing a laminate for producing the laminate according to claim 3, the method comprising:
a step of forming the silicon-containing resin layer by applying a composition for forming a silicon-containing resin layer.

12. A method for producing an optical diffractive body having a substrate and an optical diffraction grating layer disposed on the substrate and having a plurality of grooves, the method comprising:
a step of forming a resist film on the antireflection organic resin layer of the laminate according to claim 1;
a step of patterning the resist film by irradiating the resist film with light or an electron beam and developing the resist film;
a step of patterning the antireflection organic resin layer by etching using the patterned resist film as a mask; and
a step of etching the precursor layer using the patterned antireflection organic resin layer as a mask to form an optical diffraction grating layer having a plurality of grooves.

13. A method for producing an optical diffractive body having a substrate and an optical diffraction grating layer disposed on the substrate and having a plurality of grooves, the method comprising:
a step of forming a resist film on the antireflection organic resin layer of the laminate according to claim 2;
a step of patterning the resist film by irradiating the resist film with light or an electron beam and developing the resist film;
a step of patterning the inorganic mask layer and the antireflection organic resin layer by etching using the patterned resist film as a mask; and
a step of etching the precursor layer using the patterned inorganic mask layer as a mask to form an optical diffraction grating layer having a plurality of grooves.

14. The method for producing an optical diffractive body according to claim 13, further comprising:
a step of forming a sacrificial layer having an inclined thickness on the patterned inorganic mask layer.

15. A method for producing an optical diffractive body having a substrate and an optical diffraction grating layer disposed on the substrate and having a plurality of grooves, the method comprising:
a step of forming a resist film on the silicon-containing resin layer of the laminate according to claim 3;
a step of patterning the resist film by irradiating the resist film with light or an electron beam and developing the resist film;
a step of patterning the silicon-containing resin layer by etching using the patterned resist film as a mask;
a step of patterning the organic resin layer by etching using the patterned silicon-containing resin layer as a mask; and
a step of etching the precursor layer using the patterned organic resin layer as a mask to form an optical diffraction grating layer having a plurality of grooves.

16. The method for producing an optical diffractive body according to claim 15, further comprising:
a step of forming a sacrificial layer having an inclined thickness on the patterned organic resin layer.

17. A method for producing an optical diffractive body having a substrate and an optical diffraction grating layer disposed on the substrate and having a plurality of grooves, the method comprising:
a step of forming a resist film on the inorganic material layer of the laminate according to claim 4;
a step of patterning the resist film by irradiating the resist film with light or an electron beam and developing the resist film;
a step of patterning the inorganic material layer by etching using the patterned resist film as a mask;
a step of patterning the organic resin layer by etching using the patterned inorganic material layer as a mask; and
a step of etching the precursor layer using the patterned organic resin layer as a mask to form an optical diffraction grating layer having a plurality of grooves.

18. The method for producing an optical diffractive body according to claim 17, further comprising:
a step of forming a sacrificial layer having an inclined thickness on the patterned organic resin layer.

19. A method for producing an optical diffractive body having a substrate and an optical diffraction grating layer disposed on the substrate and having a plurality of grooves, the method comprising:
a step of forming a resist film on the antireflection organic resin layer of the laminate according to claim 5;
a step of patterning the resist film by irradiating the resist film with light or an electron beam and developing the resist film;
a step of patterning the inorganic material layer and the antireflection organic resin layer by etching using the patterned resist film as a mask;
a step of patterning the organic resin layer by etching using the patterned inorganic material layer as a mask; and
a step of etching the precursor layer using the patterned organic resin layer as a mask to form an optical diffraction grating layer having a plurality of grooves.

20. The method for producing an optical diffractive body according to claim 19, further comprising:
a step of forming a sacrificial layer having an inclined thickness on the patterned organic resin layer.
